# EUROPEAN PATENT APPLICATION

(11) **EP 3 937 511 A1**
(43) Date of publication of application: **12.01.2022**
(21) Application number: 20767452.4
(22) Date of filing: 07.02.2020
(51) Int. Cl.: H04R 17/00, H01L 41/083, H01L 41/18

(54) **ELECTROACOUSTIC TRANSDUCER**

(30) Priority: 07.03.2019 JP 2019041572; 16.08.2019 JP 2019149322
(71) Applicant: FUJIFILM Corporation, Tokyo 106-8620 (JP)
(72) Inventor: MIYOSHI, Tetsu, Minami-ashigara-shi, Kanagawa 250-0193 (JP)
(74) Representative: Klunker IP Patentanwälte PartG mbB
(86) International application number: PCT/JP2020/004849
(87) International publication number: WO 2020/179353

(57) **Abstract**

An object is to provide an electroacoustic transducer consisting of a vibration plate and an exciter and having good flexibility. The object is solved by providing a vibration plate and an exciter, in which a maximal value of a loss tangent of the exciter at a frequency of 1 Hz according to dynamic viscoelasticity measurement is 0.08 or more in a temperature range of 0°C to 50°C, and a product of a thickness of the exciter and a storage elastic modulus at a frequency of 1 Hz and 25°C according to the dynamic viscoelasticity measurement is at most three times a product of a thickness of the vibration plate and a Young's modulus.

## Description

### BACKGROUND OF THE INVENTION

### 1. Field of the Invention

The present invention relates to an electroacoustic transducer using an exciter.

### 2. Description of the Related Art

So-called exciters, which are brought into contact and attached to various articles and vibrate the articles to make a sound, are used for various usages.

For example, in an office, by attaching an exciter to a conference table, a whiteboard, a screen, or the like during a presentation, a telephone conference, or the like, a sound can be produced instead of a speaker. In the case of a vehicle such as an automobile, by attaching an exciter to the console, the A pillar, the roof, or the like, a guide sound, a warning sound, music, or the like can be sounded. Furthermore, in the case of an automobile that does not produce an engine sound, such as a hybrid vehicle and an electric vehicle, by attaching an exciter to the bumper or the like, a vehicle approach warning sound can be produced from the bumper or the like.

As a variable element that generates vibration in such an exciter, a combination of a coil and a magnet, a vibration motor such as an eccentric motor and a linear resonance motor, and the like are known.

It is difficult to reduce the thickness of these variable elements. In particular, the vibration motor has disadvantages that a mass body needs to be increased in order to increase the vibration force, frequency modulation for controlling the degree of vibration is difficult, and a response speed is slow.

On the other hand, in recent years, a speaker is also required to have flexibility, for example, in response to the demand corresponding to a display having flexibility. However, it is difficult for a configuration consisting of an exciter and a vibration plate to correspond to a speaker having flexibility.

It is also considered that a speaker having flexibility is obtained by bonding an exciter having flexibility to a vibration plate having flexibility.

For example, JP4960765B describes a flexible display in which a display having flexibility such as an organic electroluminescent display and a speaker having a piezoelectric film made of polyvinylidene fluoride (PVDF) interposed between electrodes and having flexibility are integrated with each other. This speaker having flexibility can be positioned as an exciter type speaker that outputs a sound by using PVDF as an exciton (exciter) and a display as a vibration plate.

### SUMMARY OF THE INVENTION

A speaker having flexibility is expected to be used in various forms such as being folded in half, being wound up to be transported, and being repeatedly bent and stretched. Furthermore, the speaker having flexibility is considered to be held for a long period of time in a folded state, a rolled state to be wound, and the like.

Therefore, the speaker having flexibility is required to have extremely high flexibility for various usages and situations. However, at present, a speaker having sufficient flexibility for various usages and situations has not been realized.

An object of the present invention is to solve such a problem in the related art, and is to provide an electroacoustic transducer having a vibration plate and an exciter and having flexibility high enough to cope with various usages and situations.

In order to achieve such an object, the present invention has the following configurations.
[1] An electroacoustic transducer comprising: a vibration plate; and an exciter provided on one principal surface of the vibration plate,
   in which a loss tangent of the exciter at a frequency of 1 Hz according to dynamic viscoelasticity measurement has a maximal value in a temperature range of 0°C to 50°C, the maximal value is 0.08 or more, and
   a product of a thickness of the exciter and a storage elastic modulus at a frequency of 1 Hz and 25°C according to the dynamic viscoelasticity measurement is at most three times a product of a thickness of the vibration plate and a Young's modulus.
[2] The electroacoustic transducer according to [1], in which a product of the thickness of the exciter and a storage elastic modulus at a frequency of 1 kHz and 25°C in a master curve obtained from the dynamic viscoelasticity measurement is at least 0.3 times the product of the thickness of the vibration plate and the Young's modulus.
[3] The electroacoustic transducer according to [1] or [2], in which the loss tangent of the exciter at a frequency of 1 kHz and 25°C in the master curve obtained from the dynamic viscoelasticity measurement is less than 0.08.
[4] The electroacoustic transducer according to any one of [1] to [3], in which the exciter has a piezoelectric film having a piezoelectric layer and electrode layers provided on both surfaces of the piezoelectric layer.
[5] The electroacoustic transducer according to [4], in which the piezoelectric layer is a polymer-based piezoelectric composite material in which piezoelectric particles are dispersed in a matrix including a polymer material.
[6] The electroacoustic transducer according to [4] or [5], in which the piezoelectric film has a protective layer provided on a surface of the electrode layer.
[7] The electroacoustic transducer according to any one of [4] to [6], in which the piezoelectric film does not have in-plane anisotropy of piezoelectric properties.
[8] The electroacoustic transducer according to any one of [4] to [7], in which the exciter has a laminate in which a plurality of layers of the piezoelectric films are laminated.
[9] The electroacoustic transducer according to [8], in which the piezoelectric films are polarized in a thickness direction, and polarization directions of the piezoelectric films adjacent to each other in the laminate are opposite to each other.
[10] The electroacoustic transducer according to [8] or [9], in which the laminate is obtained by laminating a plurality of layers of the piezoelectric film by folding back the piezoelectric film one or more times.
[11] The electroacoustic transducer according to any one of [8] to [10], in which the laminate has a bonding layer which bonds the piezoelectric films adjacent to each other.
[12] The electroacoustic transducer according to any one of [1] to [11], further comprising: a bonding layer for bonding the vibration plate to the exciter.

According to the present invention as described above, it is possible to provide an electroacoustic transducer having a vibration plate and an exciter and having flexibility high enough to cope with various usages and situations.

### BRIEF DESCRIPTION OF THE DRAWINGS

Fig. 1 is a diagram conceptually illustrating an example of an electroacoustic transducer of an embodiment of the present invention.
Fig. 2 is a diagram conceptually illustrating an example of a piezoelectric film included in an exciter of the electroacoustic transducer illustrated in Fig. 1.
Fig. 3 is a conceptual diagram for describing an example of a production method of the piezoelectric film.
Fig. 4 is a conceptual diagram for describing an example of the production method of the piezoelectric film.
Fig. 5 is a conceptual diagram for describing an example of the production method of the piezoelectric film.
Fig. 6 is a conceptual diagram for describing an example of the production method of the piezoelectric film.
Fig. 7 is a conceptual diagram for describing an example of the production method of the piezoelectric film.
Fig. 8 is a diagram conceptually illustrating another example of the exciter used in the electroacoustic transducer of the embodiment of the present invention.
Fig. 9 is a diagram conceptually illustrating another example of the exciter used in the electroacoustic transducer of the embodiment of the present invention.
Fig. 10 is a conceptual diagram for describing an example of the present invention.
Fig. 11 is a conceptual diagram for describing an example of the present invention.

### DESCRIPTION OF THE PREFERRED EMBODIMENTS

Hereinafter, an electroacoustic transducer of an embodiment of the present invention will be described in detail based on the suitable embodiments shown in the accompanying drawings.

Descriptions of the constituent requirements described below may be made based on representative embodiments of the present invention, but the present invention is not limited to such embodiments.

In the present specification, a numerical range expressed using "to" means a range including numerical values described before and after "to" as a lower limit and an upper limit.

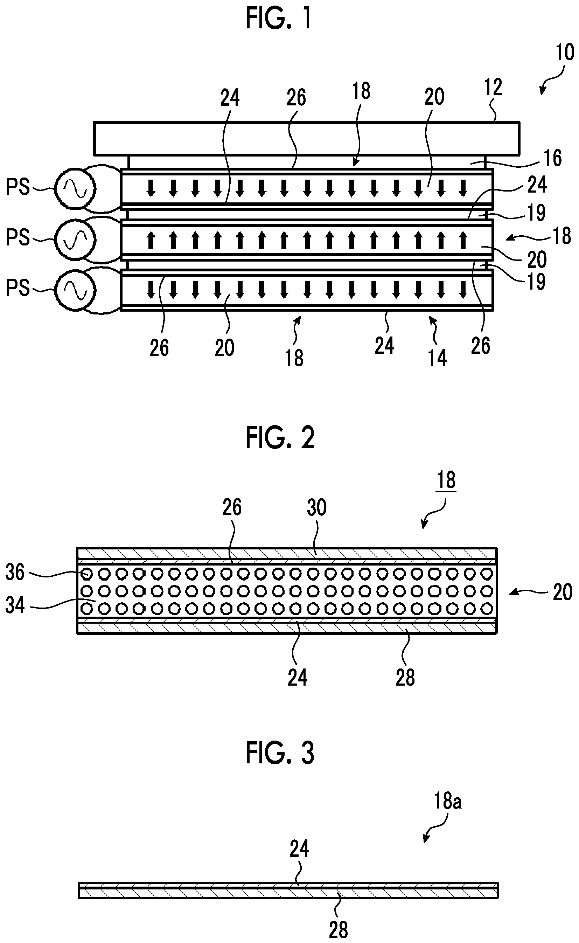

Fig. 1 conceptually illustrates an example of the electroacoustic transducer of the embodiment of the present invention.

An electroacoustic transducer 10 illustrated in Fig. 1 has an exciter 14 and a vibration plate 12. In the electroacoustic transducer 10, the exciter 14 and the vibration plate 12 are bonded to each other by a bonding layer 16.

Power sources PS for applying a driving voltage are connected to the exciter 14 (a piezoelectric film 18 described later) of the electroacoustic transducer 10.

As will be described in detail later, in the electroacoustic transducer 10, as the driving voltage is applied to the exciter 14 (the piezoelectric film 18), the exciter 14 stretches and contracts in a surface direction. The stretching and contracting of the exciter 14 in the surface direction causes the vibration plate 12 to bend, and as a result, the vibration plate 12 vibrates in a thickness direction. The vibration plate 12 generates a sound due to the vibration in the thickness direction. That is, the vibration plate 12 vibrates according to the magnitude of the voltage (driving voltage) applied to the piezoelectric film 18, and generates a sound according to the driving voltage applied to the piezoelectric film 18.

In the electroacoustic transducer 10 of the embodiment of the present invention, the vibration plate 12 has flexibility as a preferable embodiment. In the present invention, having flexibility is synonymous with having flexibility in a general interpretation, and indicates being capable of bending and being flexible, specifically, being capable of bending and stretching without causing breakage and damage.

The vibration plate 12 is not limited as long as the vibration plate 12 preferably has flexibility and satisfies the relationship with the exciter 14 described later, and various sheet-like materials (plate-like materials or films) can be used.

Examples of the vibration plate 12 include resin films made of polyethylene terephthalate (PET), polypropylene (PP), polystyrene (PS), polycarbonate (PC), polyphenylene sulfide (PPS), polymethylmethacrylate (PMMA), and polyetherimide (PEI), polyimide (PI), polyethylene naphthalate (PEN), triacetyl cellulose (TAC), cyclic olefin-based resins, or the like, foamed plastic made of expanded polystyrene, expanded styrene, expanded polyethylene, or the like, veneer boards, cork boards, leathers such as cowhide, various kinds of paperboards such as carbon sheets and Japanese paper, and various kinds of corrugated cardboard materials obtained by bonding, to one or both surfaces of a corrugated paperboard, other paperboards.

Furthermore, in the electroacoustic transducer 10 of the embodiment of the present invention, as the vibration plate 12, a display device such as an organic electroluminescence (organic light emitting diode (OLED)) display, a liquid crystal display, a micro light emitting diode (LED) display, and an inorganic electroluminescence display, a screen for a projector, and the like can be suitably used as long as they have flexibility.

In the electroacoustic transducer 10 of the illustrated example, as a preferable embodiment, the vibration plate 12 and the exciter 14 are bonded to each other by the bonding layer 16.

In the present invention, various known bonding layers 16 can be used as long as the vibration plate 12 and the exciter 14 can be bonded to each other.

Therefore, the bonding layer 16 may be a layer consisting of an adhesive, which has fluidity during bonding and thereafter becomes a solid, a layer consisting of a pressure sensitive adhesive, which is a gel-like (rubber-like) flexible solid during bonding and does not change in the gel-like state thereafter, or a layer consisting of a material having characteristics of both an adhesive and a pressure sensitive adhesive. Furthermore, the bonding layer 16 may be formed by applying a bonding agent having fluidity such as a liquid, or may be formed by using a sheet-shaped bonding agent.

Here, in the electroacoustic transducer 10 of the embodiment of the present invention, the exciter 14 is stretched and contracted to bend and vibrate the vibration plate 12 to generate a sound. Therefore, in the electroacoustic transducer 10 of the embodiment of the present invention, it is preferable that the stretching and contracting of the exciter 14 is directly transmitted to the vibration plate 12. In a case where a substance having a viscosity that relieves vibration is present between the vibration plate 12 and the exciter 14, the efficiency of transmitting the stretching and contracting energy of the exciter 14 to the vibration plate 12 is lowered, and the driving efficiency of the electroacoustic transducer 10 is also decreased.

In consideration of this point, the bonding layer 16 is preferably an adhesive layer consisting of an adhesive with which a solid and hard bonding layer 16 is obtained, rather than a pressure sensitive adhesive layer consisting of a pressure sensitive adhesive. As a more preferable bonding layer 16, specifically, a bonding layer consisting of a thermoplastic type adhesive such as a polyester-based adhesive or a styrene-butadiene rubber (SBR)-based adhesive is suitably exemplified.

Adhesion, unlike pressure sensitive adhesion, is useful in a case where a high adhesion temperature is required. Furthermore, the thermoplastic type adhesive has "relatively low temperature, short time, and strong adhesion" and is suitable.

The thickness of the bonding layer 16 is not limited, and a thickness at which sufficient bonding force (adhesive force or pressure sensitive adhesive force) can be obtained may be appropriately set depending on the material of the bonding layer 16.

Here, in the electroacoustic transducer 10 of the embodiment of the present invention, the thinner the bonding layer 16, the higher the effect of transmitting the stretching and contracting energy (vibration energy) of the exciter 14 transmitted to the vibration plate 12, and the higher the energy efficiency. In addition, in a case where the bonding layer 16 is thick and has high rigidity, there is a possibility that the stretching and contracting of the exciter 14 may be constrained.

In consideration of this point, the bonding layer 16 is preferably thin. Specifically, the thickness of the bonding layer 16 is preferably 0.1 to 50 µm, more preferably 0.1 to 30 µm, and even more preferably 0.1 to 10 µm in terms of thickness after bonding.

In the electroacoustic transducer 10, the bonding layer 16 is provided as a preferable embodiment and is not an essential constituent element.

Therefore, the electroacoustic transducer 10 does not have to have the bonding layer 16, and the vibration plate 12 and the exciter 14 may be fixed to each other by using a known pressure bonding unit, a fastening unit, a fixing unit, or the like. For example, in a case where the exciter 14 is rectangular, the electroacoustic transducer may be configured by fastening four corners with members such as bolts and nuts, or the electroacoustic transducer may be configured by fastening the four corners to a center portion with the same members.

However, in this case, in a case where the driving voltage is applied from the power source PS, the exciter 14 stretches and contracts independently of the vibration plate 12, and in some cases, only the exciter 14 bends, which results in that the stretching and contracting of the exciter 14 is not transmitted to the vibration plate 12. As described above, in a case where the exciter 14 stretches and contracts independently of the vibration plate 12, the vibration efficiency of the vibration plate 12 by the exciter 14 decreases. There is a possibility that the vibration plate 12 may not be sufficiently vibrated.

In consideration of this point, in the electroacoustic transducer of the embodiment of the present invention, it is preferable that the vibration plate 12 and the exciter 14 are bonded to each other by the bonding layer 16 as in the illustrated example.

As described above, the electroacoustic transducer 10 of the embodiment of the present invention has the vibration plate 12 and the exciter 14. As described above, the exciter 14 is for vibrating the vibration plate 12 to output a sound. Furthermore, in the present invention, both the vibration plate 12 and the exciter 14 preferably have flexibility.

In the electroacoustic transducer 10 of the illustrated example, the exciter 14 has a configuration in which three piezoelectric films 18 are laminated and the adjacent piezoelectric films 18 are bonded to each other by a bonding layer 19. The power sources PS for applying a driving voltage for stretching and contracting the piezoelectric films 18 are respectively connected to the piezoelectric films 18.

In the exciter 14 of the illustrated example, the piezoelectric film 18 is formed by interposing a polymer-based piezoelectric composite material in which piezoelectric particles are dispersed in a matrix including a polymer material between electrode layers and further interposing the resultant between protective layers as a preferable embodiment. The piezoelectric film 18 will be described in detail later.

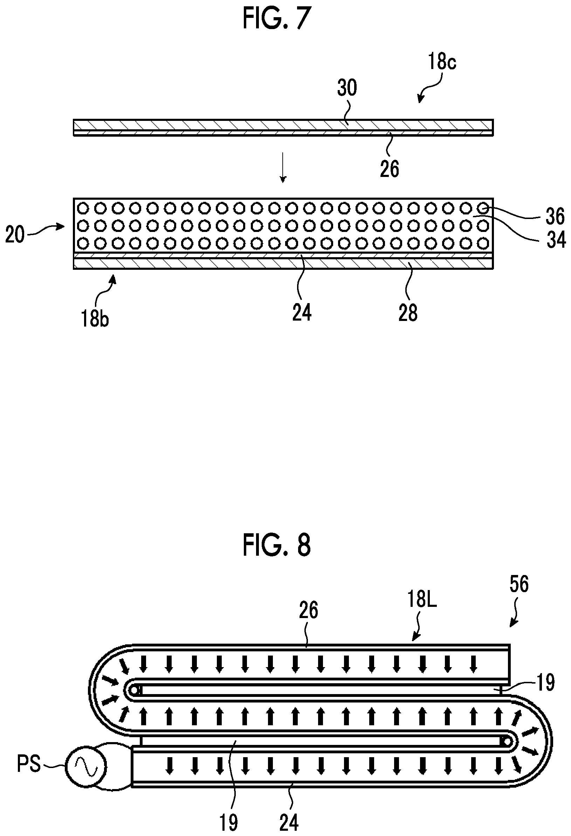

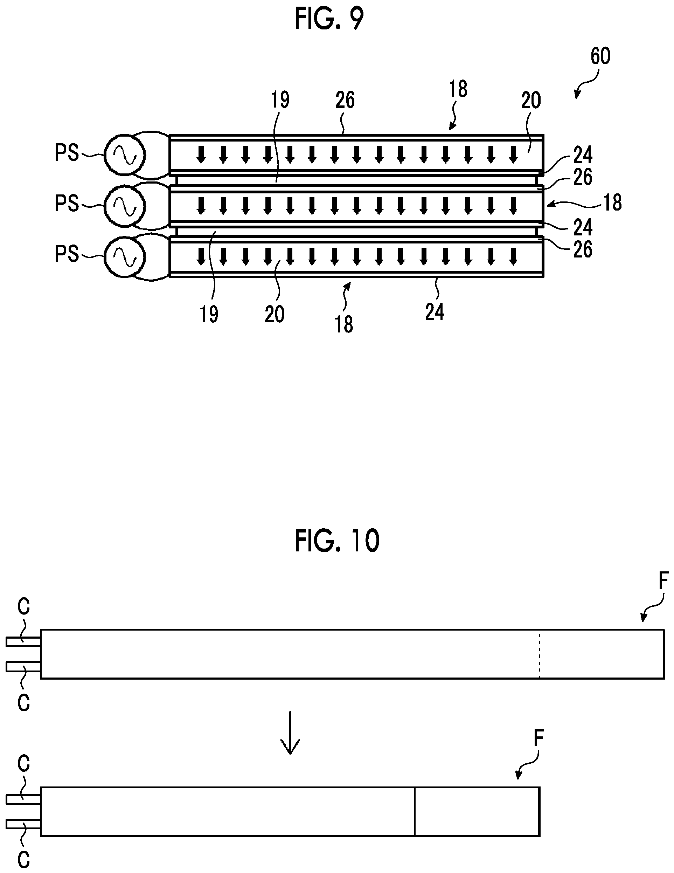

The exciter 14 illustrated in Fig. 1 is formed by laminating three piezoelectric films 18, but the present invention is not limited thereto. That is, in the electroacoustic transducer 10 of the embodiment of the present invention, the exciter may have only one layer of the piezoelectric film 18. Alternatively, in the electroacoustic transducer 10 of the embodiment of the invention, in a case where the exciter is a laminate of a plurality of layers of the piezoelectric films 18, the number of laminated piezoelectric films 18 may be two layers or four or more layers. In this regard, the same applies to an exciter 56 illustrated in Fig. 8 and an exciter 60 illustrated in Fig. 9, which will be described later.

In the electroacoustic transducer of the embodiment of the present invention, the exciter 14 is not limited to the laminate of the piezoelectric films 18. That is, in the electroacoustic transducer of the embodiment of the present invention, the exciter preferably has flexibility and can use various configurations as long as the loss tangent and the relationship with the spring constant with respect to the vibration plate at a low frequency (1 Hz) described later can be satisfied.

Preferably, the exciter satisfies one, and more preferably both of the relationship with the spring constant with respect to the vibration plate and the loss tangent at a high frequency (1 kHz) described later.

Examples of an exciter that satisfies such conditions and can be used in the present invention include an exciter having one layer or a laminate of a plurality of layers of piezoelectric films in which electrodes are provided on both surfaces of a piezoelectric layer consisting of a polymer-based piezoelectric composite material present in a viscoelastic matrix having viscoelasticity at room temperature, an exciton, and the like.

The polarization direction in the piezoelectric layer, the in-plane anisotropy of the piezoelectric properties, the laminated and bonding layers, the lamination by folding-back, and the like, which will be described below regarding the piezoelectric film 18, are the same in these exciters.

In the electroacoustic transducer 10 of the embodiment of the present invention, in the exciter 14, the loss tangent (tanδ) at a frequency of 1 Hz according to dynamic viscoelasticity measurement has a maximal value in a temperature range of 0°C to 50°C, and the maximal value in the temperature range of 0°C to 50°C is 0.08 or more. Furthermore, in the electroacoustic transducer 10 of the embodiment of the present invention, the product of the thickness of the exciter 14 and the storage elastic modulus (E') at a frequency of 1 Hz and 25°C according to the dynamic viscoelasticity measurement is at most three times the product of the thickness of vibration plate 12 and Young's modulus.

Preferably, in the electroacoustic transducer 10 of the embodiment of the present invention, the product of the thickness of the exciter 14 and the storage elastic modulus at a frequency of 1 kHz and 25°C in a master curve obtained from the dynamic viscoelasticity measurement is at least 0.3 times the product of the thickness of vibration plate 12 and Young's modulus.

Also, preferably, in the electroacoustic transducer 10 of the embodiment of the present invention, the exciter 14 has a loss tangent of less than 0.08 at a frequency of 1 kHz and 25°C in the master curve obtained from the dynamic viscoelasticity measurement.

By having such a configuration, the electroacoustic transducer 10 of the embodiment of the present invention realizes an electroacoustic transducer having excellent flexibility and preferably excellent acoustic properties.

In the present invention, the storage elastic modulus (Young's modulus) and the loss tangent measurement (dynamic viscoelasticity measurement) may be performed by a known method using a dynamic viscoelasticity measuring machine. Examples of the dynamic viscoelasticity measuring machine include the DMS6100 viscoelasticity spectrometer manufactured by SII NanoTechnology Inc.

Examples of the measurement conditions include a measurement frequency of 0.1 to 20 Hz (0.1 Hz, 0.2 Hz, 0.5 Hz, 1 Hz, 2 Hz, 5 Hz, 10 Hz, and 20 Hz), a measurement temperature of -20°C to 100°C, a temperature rising rate of 2 °C/min (in a nitrogen atmosphere), a sample size of 40 mm × 10 mm (including the clamped region), and a chuck-to-chuck distance of 20 mm.

In the electroacoustic transducer 10 having flexibility, the exciter 14 preferably meets the following requirements.

### (i) Flexibility

For example, in a case of being gripped in a state of being loosely bent like a newspaper or a magazine as a portable device, the exciter 14 is continuously subjected to large bending deformation from the outside at a relatively slow vibration of less than or equal to a few Hz. In this case, in a case where the exciter 14 is hard, large bending stress is generated to that extent, which may lead to breakage. Accordingly, the exciter 14 is required to have suitable flexibility. In addition, in a case where strain energy is diffused into the outside as heat, the stress is able to be relieved. Therefore, the exciter 14 is required to have a moderately large loss tangent when subjected to large bending deformation at a relatively slow vibration of less than or equal to a few Hz.

### (ii) Acoustic Quality

In the electroacoustic transducer 10, the exciter 14 is stretched and contracted at a frequency of an audio band of 20 Hz to 20 kHz, and the vibration plate 12 vibrates due to the stretching and contracting energy such that a sound is reproduced. Therefore, in order to increase the transmission efficiency of vibration energy, the exciter 14 is required to have suitable hardness at a frequency of the audio band.

In the exciter 14, the loss tangent at a frequency of 1 Hz according to the dynamic viscoelasticity measurement has a maximal value of 0.08 or more in a temperature range of 0°C to 50°C, and furthermore, the product of the thickness of the exciter 14 and the storage elastic modulus at a frequency of 1 Hz and 25°C according to the dynamic viscoelasticity measurement is at most three times the product of the thickness of vibration plate 12 and the Young's modulus. That is, in the exciter 14, the maximal value at which the loss tangent at a frequency of 1 Hz by dynamic viscoelasticity measurement is 0.08 or more is in the temperature range of 0°C to 50°C. In the present invention, the temperature range of 0°C to 50°C is the temperature range of room temperature.

This indicates that the exciter 14 is flexible for slow frequency movement at room temperature, and in a case where the exciter 14 has a large loss tangent, that is, is bent, the elastic strain energy quickly becomes heat and diffuses.

The electroacoustic transducer 10 of the embodiment of the present invention has flexibility. Therefore, when the electroacoustic transducer 10 is not in use, the electroacoustic transducer 10 is considered to be held for a long period of time in a folded state, a rolled state to be wound, or the like. In this case, in a case where the loss tangent (internal loss) of the exciter 14 is small, the elastic strain energy due to bending is not diffused as heat. As a result, the piezoelectric film 18 is cracked and broken, and the piezoelectric films 18 that are laminated and bonded together are peeled off from each other.

On the other hand, in the exciter 14 of the electroacoustic transducer 10 of the embodiment of the present invention, the maximal value of the loss tangent at a frequency of 1 Hz according to a dynamic viscoelasticity test at room temperature, that is, in a temperature range of 0°C to 50°C is 0.08 or more. As a result, the exciter 14 can suitably diffuse the elastic strain energy due to bending as heat with respect to a slow movement due to an external force, so that the above-mentioned damage can be prevented, that is, high flexibility can be obtained.

The maximal value of the loss tangent of the exciter 14 at a frequency of 1 Hz according to the dynamic viscoelasticity test in the temperature range of 0°C to 50°C is preferably 0.1 or more, and more preferably 0.3 or more.

The upper limit of the maximal value of the loss tangent at a frequency of 1 Hz according to the dynamic viscoelasticity test at 0°C to 50°C is not limited. In consideration of the materials available for the exciter 14, a preferable configuration of the exciter 14, and the like, the maximal value of the loss tangent at a frequency of 1 Hz according to the dynamic viscoelasticity test at 0°C to 50°C is preferably 0.8 or less.

From the viewpoint of more suitably obtaining the above-described effect, in the exciter 14, it is preferable that the maximum value of the loss tangent at a frequency of 1 Hz is present in the temperature range of 0°C to 50°C.

On the other hand, the vibration plate 12 has a certain degree of rigidity. In a case where an exciter having rigidity is combined with the vibration plate 12, the electroacoustic transducer becomes hard and difficult to bend and has poor flexibility.

On the other hand, in the electroacoustic transducer 10 of the embodiment of the present invention, the product of the thickness of the exciter 14 and the storage elastic modulus at a frequency of 1 Hz and 25°C according to the dynamic viscoelasticity measurement is at most three times the product of the thickness of the vibration plate 12 and the Young's modulus. That is, in the exciter 14, the spring constant with respect to a slow movement at room temperature is at most three times that of the vibration plate 12.

With this configuration, the exciter 14 can be flexible with respect to a slow movement due to an external force such as bending and rolling, that is, exhibits good flexibility with respect to a slow movement.

In the electroacoustic transducer 10 of the embodiment of the present invention, the product of the thickness of the exciter 14 and the storage elastic modulus at a frequency of 1 Hz and 25°C according to the dynamic viscoelasticity measurement is preferably at most one time, and more preferably at most 0.3 times the product of the thickness of the vibration plate 12 and the Young's modulus.

The lower limit of the product of the thickness of the exciter 14 and the storage elastic modulus at a frequency of 1 Hz and 25°C according to the dynamic viscoelasticity measurement with respect to the product of the thickness of the vibration plate 12 and the Young's modulus is not limited. In consideration of the material used for the exciter 14, a preferable configuration of the exciter 14, and the like, the product of the thickness of the exciter 14 and the storage elastic modulus at a frequency of 1 Hz and 25°C according to the dynamic viscoelasticity measurement with respect to the product of the thickness of the vibration plate 12 and the Young's modulus is preferably at least 0.1 times.

That is, the electroacoustic transducer 10 of the embodiment of the present invention is flexible with respect to a slow movement due to an external force such as bending by a user and rolling, and can diffuse the elastic strain energy due to bending as heat, thereby having excellent flexibility.

In the electroacoustic transducer 10 of the embodiment of the present invention, the product of the thickness of the exciter 14 and the storage elastic modulus at a frequency of 1 kHz and 25°C in the master curve obtained from the dynamic viscoelasticity measurement is preferably at least 0.3 times the product of the thickness of the vibration plate 12 and the Young's modulus. That is, in the exciter 14, the spring constant for a fast movement at room temperature is preferably at least 0.3 times that of the vibration plate 12.

The electroacoustic transducer 10 generates a sound by vibrating the vibration plate 12 by the stretching and contracting of the exciter 14 in the surface direction. Therefore, the exciter 14 preferably has a certain degree of rigidity (hardness, stiffness) with respect to the vibration plate 12 at a frequency of the audio band (20 Hz to 20 kHz).

In the electroacoustic transducer 10 of the embodiment of the present invention, the product of the thickness of the exciter 14 and the storage elastic modulus at a frequency of 1 kHz and 25°C in the master curve obtained from the dynamic viscoelasticity measurement is set to preferably at least 0.3 times, more preferably at least 0.5 times, and even more preferably at least 1.0 time the product of the thickness of the vibration plate 12 and the Young's modulus. That is, in the exciter 14, the spring constant with respect to a fast movement at room temperature is preferably at least 0.3 times, more preferably at least 0.5 times, and even more preferably at least 1.0 time that of the vibration plate 12.

Accordingly, at a frequency of the audio band, the rigidity of the exciter 14 with respect to the vibration plate 12 is sufficiently secured, and the electroacoustic transducer 10 can output a sound with high sound pressure with high energy efficiency.

The upper limit of the product of the thickness of the exciter 14 and the storage elastic modulus at a frequency of 1 kHz and 25°C according to the dynamic viscoelasticity measurement with respect to the product of the thickness of the vibration plate 12 and the Young's modulus is not limited. In consideration of the materials available for the exciter 14, a preferable configuration of the exciter 14, and the like, the product of the thickness of the exciter 14 and the storage elastic modulus at a frequency of 1 kHz and 25°C according to the dynamic viscoelasticity measurement with respect to the product of the thickness of the vibration plate 12 and the Young's modulus is preferably at most 10 times.

In addition, in the electroacoustic transducer 10 of the embodiment of the present invention, the exciter 14 preferably has a loss tangent of less than 0.08 at a frequency of 1 kHz and 25°C in the master curve obtained from the dynamic viscoelasticity measurement. That is, it is preferable that the exciter 14 has a small loss tangent for a fast movement at room temperature.

As described above, the electroacoustic transducer 10 generates a sound by vibrating the vibration plate 12 by the stretching and contracting of the exciter 14 in the surface direction. Therefore, it is preferable that the exciter 14 has a high energy at a frequency of the audio band.

In the electroacoustic transducer 10 of the embodiment of the present invention, the loss tangent of the exciter 14 at a frequency of 1 kHz and 25°C in the master curve obtained from the dynamic viscoelasticity measurement is preferably less than 0.08, more preferably less than 0.05, and even more preferably less than 0.03. Accordingly, at a frequency of the audio band, the thermal energy due to the stretching and contracting of the exciter 14 is less likely to be diffused, the vibration plate 12 is given higher energy, and the electroacoustic transducer 10 can output a sound with high sound pressure with high energy efficiency.

The lower limit of the loss tangent of the exciter 14 at a frequency of 1 kHz and 25°C in the master curve obtained from the dynamic viscoelasticity measurement is not limited. In consideration of the materials available for the exciter 14, a preferable configuration of the exciter 14, and the like, the loss tangent of the exciter 14 at a frequency of 1 kHz and 25°C in the master curve obtained from the dynamic viscoelasticity measurement is preferably 0.01 or more.

As described above, in the electroacoustic transducer 10 of the illustrated example, the exciter 14 has a configuration in which three piezoelectric films 18 are laminated and the adjacent piezoelectric films 18 are bonded by the bonding layer 19.

Fig. 2 conceptually illustrates the piezoelectric film 18 in a cross-sectional view.

As illustrated in Fig. 2, the piezoelectric film 18 has a piezoelectric layer 20 which is a sheet-like material having piezoelectric properties, a lower thin film electrode 24 laminated on one surface of the piezoelectric layer 20, a lower protective layer 28 laminated on the lower thin film electrode 24, an upper thin film electrode 26 laminated on the other surface of the piezoelectric layer 20, and an upper protective layer 30 laminated on the upper thin film electrode 26. As will be described later, the piezoelectric film 18 is polarized in the thickness direction as a preferable embodiment.

In addition, in order to simplify the drawing and clearly show the configuration of the exciter 14, the lower protective layer 28 and the upper protective layer 30 are omitted in Fig. 1.

In the piezoelectric film 18, as a preferable embodiment, as conceptually illustrated in Fig. 2, the piezoelectric layer 20 consists of a polymer-based piezoelectric composite material in which piezoelectric particles 36 are dispersed in a viscoelastic matrix 34 consisting of a polymer material having viscoelasticity at room temperature. Furthermore, in the present specification, the "room temperature" indicates a temperature range of approximately 0°C to 50°C as described above.

Here, it is preferable that the polymer-based piezoelectric composite material (the piezoelectric layer 20) has the following requirements.

### (i) Flexibility

For example, in a case of being gripped in a state of being loosely bent like a newspaper or a magazine as a portable device, the exciter 14 is continuously subjected to large bending deformation from the outside at a relatively slow vibration of less than or equal to a few Hz. In this case, in a case where the polymer-based piezoelectric composite material is hard, large bending stress is generated to that extent, and a crack is generated at the interface between the viscoelastic matrix 34 and the piezoelectric particles 36, possibly leading to breakage. Accordingly, the polymer-based piezoelectric composite material is required to have suitable flexibility. In addition, in a case where strain energy is diffused into the outside as heat, the stress is able to be relieved. Accordingly, the loss tangent of the polymer-based piezoelectric composite material is required to be suitably large.

As described above, a flexible polymer-based piezoelectric composite material used in the exciter 14 is required to be rigid with respect to a vibration of 20 Hz to 20 kHz, and be flexible with respect to a vibration of less than or equal to a few Hz. In addition, the loss tangent of the polymer-based piezoelectric composite material is required to be suitably large with respect to the vibration of all frequencies of less than or equal to 20 kHz.

Furthermore, it is preferable that the spring constant can be easily controlled by lamination according to the rigidity of a mating material (vibration plate) to be attached. In this case, the thinner the bonding layer 19 is, the higher the energy efficiency can be.

In general, a polymer solid has a viscoelasticity relieving mechanism, and a molecular movement having a large scale is observed as a decrease (relief) in a storage elastic modulus (Young's modulus) or a maximal value (absorption) in a loss elastic modulus along with an increase in a temperature or a decrease in a frequency. Among them, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer-based piezoelectric composite material (the piezoelectric layer 20), the polymer material of which the glass transition point is room temperature, in other words, the polymer material having viscoelasticity at room temperature is used in the matrix, and thus the polymer-based piezoelectric composite material which is rigid with respect to a vibration of 20 Hz to 20 kHz and is flexible with respect to a vibration of less than or equal to a few Hz is realized. In particular, from a viewpoint of preferably exhibiting such behavior, it is preferable that a polymer material of which the glass transition temperature at a frequency of 1 Hz is room temperature, that is, 0°C to 50°C is used in the matrix of the polymer-based piezoelectric composite material.

As the polymer material having viscoelasticity at room temperature, various known materials are able to be used. Preferably, as the polymer material, a polymer material of which the maximal value of a loss tangent Tanδ at a frequency of 1 Hz according to a dynamic viscoelasticity test at room temperature is greater than or equal to 0.5 is used.

Accordingly, in a case where the polymer-based piezoelectric composite material is slowly bent due to an external force, stress concentration on the interface between the polymer matrix and the piezoelectric particles at the maximum bending moment portion is relieved, and thus high flexibility is able to be expected.

In addition, it is preferable that, in the polymer material having viscoelasticity at room temperature, a storage elastic modulus (E') at a frequency of 1 Hz according to dynamic viscoelasticity measurement is greater than or equal to 100 MPa at 0°C and is less than or equal to 10 MPa at 50°C.

Accordingly, it is possible to reduce a bending moment which is generated in a case where the polymer-based piezoelectric composite material is slowly bent due to the external force, and it is possible to make the polymer-based piezoelectric composite material rigid with respect to an acoustic vibration of 20 Hz to 20 kHz.

In addition, it is more suitable that the relative permittivity of the polymer material having viscoelasticity at room temperature is greater than or equal to 10 at 25°C. Accordingly, in a case where a voltage is applied to the polymer-based piezoelectric composite material, a higher electric field is applied to the piezoelectric particles in the polymer matrix, and thus a large deformation amount is able to be expected.

However, in consideration of securing good moisture resistance or the like, it is suitable that the relative permittivity of the polymer material is less than or equal to 10 at 25°C.

As the polymer material having viscoelasticity at room temperature and satisfying such conditions, cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, polybutyl methacrylate, and the like are exemplified. In addition, as these polymer materials, a commercially available product such as Hybrar 5127 (manufactured by Kuraray Co., Ltd.) is also able to be suitably used. Among them, as the polymer material, a material having a cyanoethyl group is preferably used, and cyanoethylated PVA is particularly preferably used.

Furthermore, only one of these polymer materials may be used, or a plurality of types thereof may be used in combination (mixture).

The viscoelastic matrix 34 using such a polymer material having viscoelasticity at room temperature, as necessary, may use a plurality of polymer materials in combination.

That is, in order to control dielectric properties or mechanical properties, other dielectric polymer materials may be added to the viscoelastic matrix 34 in addition to the viscoelastic material such as cyanoethylated PVA, as necessary.

As the dielectric polymer material which is able to be added to the viscoelastic matrix, for example, a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, and a polyvinylidene fluoride-tetrafluoroethylene copolymer, a polymer having a cyano group or a cyanoethyl group such as a vinylidene cyanide-vinyl acetate copolymer, cyanoethyl cellulose, cyanoethyl hydroxy saccharose, cyanoethyl hydroxy cellulose, cyanoethyl hydroxy pullulan, cyanoethyl methacrylate, cyanoethyl acrylate, cyanoethyl hydroxy ethyl cellulose, cyanoethyl amylose, cyanoethyl hydroxy propyl cellulose, cyanoethyl dihydroxy propyl cellulose, cyanoethyl hydroxy propyl amylose, cyanoethyl polyacryl amide, cyanoethyl polyacrylate, cyanoethyl pullulan, cyanoethyl polyhydroxy methylene, cyanoethyl glycidol pullulan, cyanoethyl saccharose, and cyanoethyl sorbitol, and a synthetic rubber such as nitrile rubber or chloroprene rubber are exemplified.

Among them, a polymer material having a cyanoethyl group is suitably used.

Furthermore, the dielectric polymer added to the viscoelastic matrix 34 of the piezoelectric layer 20 in addition to the material having viscoelasticity at room temperature such as cyanoethylated PVA is not limited to one dielectric polymer, and a plurality of dielectric polymers may be added.

In addition, for the purpose of controlling the glass transition point Tg, a thermoplastic resin such as a vinyl chloride resin, polyethylene, polystyrene, a methacrylic resin, polybutene, and isobutylene, and a thermosetting resin such as a phenol resin, a urea resin, a melamine resin, an alkyd resin, or mica may be added to the viscoelastic matrix 34 in addition to the dielectric polymer.

Furthermore, for the purpose of improving pressure sensitive adhesiveness, a viscosity imparting agent such as rosin ester, rosin, terpene, terpene phenol, and a petroleum resin may be added to the viscoelastic matrix 34.

The amount of materials added to the viscoelastic matrix 34 of the piezoelectric layer 20 in a case where materials other than the polymer material having viscoelasticity such as cyanoethylated PVA is not particularly limited, and it is preferable that a ratio of the added materials to the viscoelastic matrix 34 is less than or equal to 30 mass%.

Accordingly, it is possible to exhibit properties of the polymer material to be added without impairing the viscoelasticity relieving mechanism of the viscoelastic matrix 34, and thus a preferable result is able to be obtained from a viewpoint of increasing a dielectric constant, of improving heat resistance, and of improving adhesiveness between the piezoelectric particles 36 and the electrode layer.

The piezoelectric particles 36 consist of ceramics particles having a perovskite type or wurtzite type crystal structure.

As the ceramics particles forming the piezoelectric particles 36, for example, lead zirconate titanate (PZT), lead lanthanum zirconate titanate (PLZT), barium titanate (BaTiO₃), zinc oxide (ZnO), and a solid solution (BFBT) of barium titanate and bismuth ferrite (BiFe₃) are exemplified.

Furthermore, only one of these piezoelectric particles 36 may be used, or a plurality of types thereof may be used in combination (mixture).

The particle diameter of the piezoelectric particles 36 is not limited, and may be appropriately selected depending on the size of the piezoelectric film 18 and the usage of the exciter 14. The particle diameter of the piezoelectric particles 36 is preferably 1 to 10 µm.

By setting the particle diameter of the piezoelectric particles 36 to be in the range described above, a preferable result is able to be obtained from a viewpoint of allowing the piezoelectric film 18 to achieve both high piezoelectric properties and flexibility.

In addition, in Fig. 2, the piezoelectric particles 36 in the piezoelectric layer 20 are uniformly dispersed in the viscoelastic matrix 34 with regularity. However, the present invention is not limited thereto.

That is, in the viscoelastic matrix 34, the piezoelectric particles 36 in the piezoelectric layer 20 are preferably uniformly dispersed, and may also be irregularly dispersed.

In the piezoelectric film 18, a quantitative ratio of the viscoelastic matrix 34 and the piezoelectric particles 36 in the piezoelectric layer 20 is not limited, and may be appropriately set according to the size in the surface direction or the thickness of the piezoelectric film 18, the usage of the exciter 14, properties required for the piezoelectric film 18, and the like.

The volume fraction of the piezoelectric particles 36 in the piezoelectric layer 20 is preferably 30% to 80%. The volume fraction of the piezoelectric particles 36 in the piezoelectric layer 20 is set to more preferably more than or equal to 50%, and therefore even more preferably 50% to 80%.

By setting the quantitative ratio of the viscoelastic matrix 34 and the piezoelectric particles 36 to be in the range described above, high piezoelectric properties and flexibility can be compatible with each other, which is preferable.

In the piezoelectric film 18, the thickness of the piezoelectric layer 20 is not particularly limited, and may be appropriately set according to the usage of the electroacoustic transducer 10, the number of laminated piezoelectric films in the exciter 14, properties required for the piezoelectric film 18, and the like.

The thicker the piezoelectric layer 20, the more advantageous it is in terms of rigidity such as the stiffness of a so-called sheet-like material, but the voltage (potential difference) required to stretch and contract the piezoelectric film 18 by the same amount increases.

The thickness of the piezoelectric layer 20 is preferably 10 to 300 µm, more preferably 20 to 200 µm, and even more preferably 30 to 150 µm.

By setting the thickness of the piezoelectric layer 20 to be in the range described above, it is possible to obtain a preferable result from a viewpoint of compatibility between securing the rigidity and appropriate flexibility, or the like.

As illustrated in Fig. 2, the piezoelectric film 18 of the illustrated example has a configuration in which the lower thin film electrode 24 is provided on one surface of the piezoelectric layer 20, the lower protective layer 28 is provided thereon, the upper thin film electrode 26 is provided on the other surface of the piezoelectric layer 20, and the upper protective layer 30 is provided thereon. Here, the upper thin film electrode 26 and the lower thin film electrode 24 form an electrode pair.

In the present invention, "upper" and "lower" in the lower thin film electrode 24, the lower protective layer 28, the upper thin film electrode 26, and the upper protective layer 30 are named according to the drawings for convenience in order to describe the piezoelectric film 12. Therefore, "upper" and "lower" in the piezoelectric film 12 have no technical meaning and are irrelevant to the actual usage state.

In addition to these layers, the piezoelectric film 18 has, for example, an electrode lead-out portion that leads out the electrodes from the upper thin film electrode 26 and the lower thin film electrode 24, and the electrode lead-out portion is connected to the power source PS. Furthermore, the piezoelectric film 18 may have an insulating layer which covers a region where the piezoelectric layer 20 is exposed for preventing a short circuit or the like.

That is, the piezoelectric film 18 has a configuration in which both surfaces of the piezoelectric layer 20 are interposed between the electrode pair, that is, the upper thin film electrode 26 and the lower thin film electrode 24 and the laminate is further interposed between the lower protective layer 28 and the upper protective layer 30.

As described above, in the piezoelectric film 18, the region interposed between the upper thin film electrode 26 and the lower thin film electrode 24 is stretched and contracted according to an applied voltage.

In the exciter 14, the lower protective layer 28 and the upper protective layer 30 of the piezoelectric film 18 are provided as a preferable embodiment rather than essential constituent requirements.

In the piezoelectric film 18, the lower protective layer 28 and the upper protective layer 30 have a function of covering the upper thin film electrode 26 and the lower thin film electrode 24 and applying appropriate rigidity and mechanical strength to the piezoelectric layer 20. That is, there may be a case where, in the piezoelectric film 18, the piezoelectric layer 20 consisting of the viscoelastic matrix 34 and the piezoelectric particles 36 exhibits extremely superior flexibility under bending deformation at a slow vibration but has insufficient rigidity or mechanical strength depending on the usage. As a compensation for this, the piezoelectric film 18 is provided with the lower protective layer 28 and the upper protective layer 30.

In the exciter 14 illustrated in Fig. 1, as a preferable embodiment, all the piezoelectric films 18 have both the lower protective layer 28 and the upper protective layer 30. However, the present invention is not limited thereto, and a piezoelectric film having the protective layer and a piezoelectric film not having the protective layer may be mixed. Furthermore, in a case where the piezoelectric film has the protective layer, the piezoelectric film may have only the lower protective layer 28 or only the upper protective layer 30. As an example, the exciter 14 having a three-layer configuration as illustrated in Fig. 1 may have a configuration in which the piezoelectric film in the uppermost layer in the figure has only the upper protective layer 30, and the piezoelectric film in the middle has no protective layer, and the piezoelectric film in the lowermost layer has only the lower protective layer 28.

The lower protective layer 28 and the upper protective layer 30 are not limited, and may use various sheet-like materials. As an example, various resin films are suitably exemplified.

Among them, by the reason of excellent mechanical properties and heat resistance, a resin film consisting of polyethylene terephthalate (PET), polypropylene (PP), polystyrene (PS), polycarbonate (PC), polyphenylene sulfide (PPS), polymethylmethacrylate (PMMA), polyetherimide (PEI), polyimide (PI), polyethylene naphthalate (PEN), triacetyl cellulose (TAC), or a cyclic olefin-based resin is suitably used.

There is also no limitation on the thicknesses of the lower protective layer 28 and the upper protective layer 30. In addition, the thicknesses of the lower protective layer 28 and the upper protective layer 30 may basically be the same or different from each other.

Here, in a case where the rigidity of the lower protective layer 28 and the upper protective layer 30 is too high, not only is the stretching and contracting of the piezoelectric layer 20 constrained, but also the flexibility is impaired. Therefore, it is advantageous in a case where the thicknesses of lower protective layer 28 and the upper protective layer 30 are smaller unless mechanical strength or good handleability as a sheet-like material is required.

In the piezoelectric film 18, in a case where the thickness of the lower protective layer 28 and the upper protective layer 30 is at most twice the thickness of the piezoelectric layer 20, it is possible to obtain a preferable result from a viewpoint of compatibility between securing the rigidity and appropriate flexibility, or the like.

For example, in a case where the thickness of the piezoelectric layer 20 is 50 µm and the lower protective layer 28 and the upper protective layer 30 consist of PET, the thickness of the upper protective layer 30 and the lower protective layer 28 is preferably less than or equal to 100 µm, more preferably less than or equal to 50 µm, and even more preferably less than or equal to 25 µm.

In the piezoelectric film 18, the lower thin film electrode 24 is formed between the piezoelectric layer 20 and the lower protective layer 28, and the upper thin film electrode 26 is formed between the piezoelectric layer 20 and the upper protective layer 30. In the following description, the lower thin film electrode 24 is also referred to as a lower electrode 24, and the upper thin film electrode 26 is also referred to as an upper electrode 26.

The lower electrode 24 and the upper electrode 26 are provided to apply a voltage to the piezoelectric layer 20 (the piezoelectric film 18).

In the present invention, a forming material of the lower electrode 24 and the upper electrode 26 is not limited, and as the forming material, various conductive bodies are able to be used. Specifically, carbon, palladium, iron, tin, aluminum, nickel, platinum, gold, silver, copper, titanium, chromium, and molybdenum, alloys thereof, laminates and composites of these metals and alloys, indium-tin oxide, and the like are exemplified. Among them, copper, aluminum, gold, silver, platinum, and indium-tin oxide are suitably exemplified as the lower electrode 24 and the upper electrode 26.

In addition, a forming method of the lower electrode 24 and the upper electrode 26 is not limited, and various known methods such as a vapor-phase deposition method (a vacuum film forming method) such as vacuum vapor deposition or sputtering, film formation using plating, and a method of bonding a foil formed of the materials described above are able to be used.

Among them, in particular, by the reason that the flexibility of the piezoelectric film 18 is able to be secured, a thin film made of copper, aluminum, or the like formed by using the vacuum vapor deposition is suitably used as the lower electrode 24 and the upper electrode 26. Among them, in particular, the copper thin film formed by using the vacuum vapor deposition is suitably used.

There is no limitation on the thickness of the lower electrode 24 and the upper electrode 26. In addition, the thicknesses of the lower electrode 24 and the upper electrode 26 may basically be the same or different from each other.

Here, similarly to the lower protective layer 28 and upper protective layer 30 mentioned above, in a case where the rigidity of the lower electrode 24 and the upper electrode 26 is too high, not only is the stretching and contracting of the piezoelectric layer 20 constrained, but also the flexibility is impaired. Therefore, it is advantageous in a case where the thicknesses of lower electrode 24 and the upper electrode 26 are smaller as long as electrical resistance is not excessively high.

In the piezoelectric film 18, in a case where the product of the thicknesses of the lower electrode 24 and the upper electrode 26 and the Young's modulus is less than the product of the thicknesses of the lower protective layer 28 and the upper protective layer 30 and the Young's modulus, the flexibility is not considerably impaired, which is suitable.

For example, it is assumed that the lower protective layer 28 and the upper protective layer 30 are made of PET (Young's modulus: about 5 GPa), and the lower electrode 24 and the upper electrode 26 are made of copper (Young's modulus: about 130 GPa). In this case, assuming that the thickness of the lower protective layer 28 and the upper protective layer 30 is 25 µm, the thickness of the lower electrode 24 and the upper electrode 26 is preferably 1.0 µm or less, more preferably 0.3 µm or less, and particularly preferably 0.1 µm or less.

As described above, the piezoelectric film 18 has a configuration in which the piezoelectric layer 20 in which the piezoelectric particles 36 are dispersed in the viscoelastic matrix 34 including the polymer material having viscoelasticity at room temperature is interposed between the lower electrode 24 and the upper electrode 26 and the laminate is interposed between the lower protective layer 28 and the upper protective layer 30.

In the piezoelectric film 18, it is preferable that the maximal value of the loss tangent (Tanδ) at a frequency of 1 Hz according to the dynamic viscoelasticity measurement exists at room temperature, and it is more preferable that a maximal value of greater than or equal to 0.1 exists at room temperature.

Accordingly, even in a case where the piezoelectric film 18 is subjected to large bending deformation from the outside at a relatively slow vibration of less than or equal to a few Hz, it is possible to effectively diffuse the strain energy to the outside as heat, and thus it is possible to prevent a crack from being generated on the interface between the polymer matrix and the piezoelectric particles.

In the piezoelectric film 18, it is preferable that the storage elastic modulus (E') at a frequency of 1 Hz according to the dynamic viscoelasticity measurement is 10 to 30 GPa at 0°C, and 1 to 10 GPa at 50°C.

Accordingly, the piezoelectric film 18 is able to have large frequency dispersion in the storage elastic modulus at room temperature. That is, the piezoelectric film 18 is able to be rigid with respect to a vibration of 20 Hz to 20 kHz, and is able to be flexible with respect to a vibration of less than or equal to a few Hz.

In addition, in the piezoelectric film 18, it is preferable that the product of the thickness and the storage elastic modulus at a frequency of 1 Hz according to the dynamic viscoelasticity measurement is 1.0 × 10⁶ to 2.0 × 10⁶ N/m at 0°C, and 1.0 × 10⁵ to 1.0 × 10⁶ N/m at 50°C.

Accordingly, the piezoelectric film 18 is able to have appropriate rigidity and mechanical strength within a range not impairing the flexibility and the acoustic properties.

Furthermore, in the piezoelectric film 18, it is preferable that the loss tangent at a frequency of 1 kHz at 25°C is greater than or equal to 0.05 in the master curve obtained from the dynamic viscoelasticity measurement.

Accordingly, the frequency properties of a speaker using the piezoelectric film 18 are smoothened, and thus it is also possible to decrease the changed amount of acoustic quality in a case where the lowest resonance frequency f₀ is changed according to a change in the curvature of the speaker.

Next, an example of a manufacturing method of the piezoelectric film 18 will be described with reference to Figs. 3 to 7.

First, as illustrated in Fig. 3, a sheet-like material 18a is prepared in which the lower electrode 24 is formed on the lower protective layer 28. The sheet-like material 18a may be produced by forming a copper thin film or the like as the lower electrode 24 on the surface of the lower protective layer 28 using vacuum vapor deposition, sputtering, plating, or the like.

In a case where the lower protective layer 28 is extremely thin, and thus the handleability is degraded, the lower protective layer 28 with a separator (temporary support) may be used as necessary. As the separator, a PET having a thickness of 25 to 100 µm, and the like are able to be used. The separator may be removed after thermal compression bonding of the upper electrode 26 and the upper protective layer 30 and before laminating any member on the lower protective layer 28.

On the other hand, a coating material is prepared by dissolving a polymer material having viscoelasticity (hereinafter, referred to as a viscoelastic material) at room temperature, such as cyanoethylated PVA, in an organic solvent, further adding the piezoelectric particles 36 such as PZT particles thereto, and stirring and dispersing the resultant. The organic solvent is not limited, and various organic solvents such as dimethylformamide (DMF), methyl ethyl ketone, and cyclohexanone are able to be used.

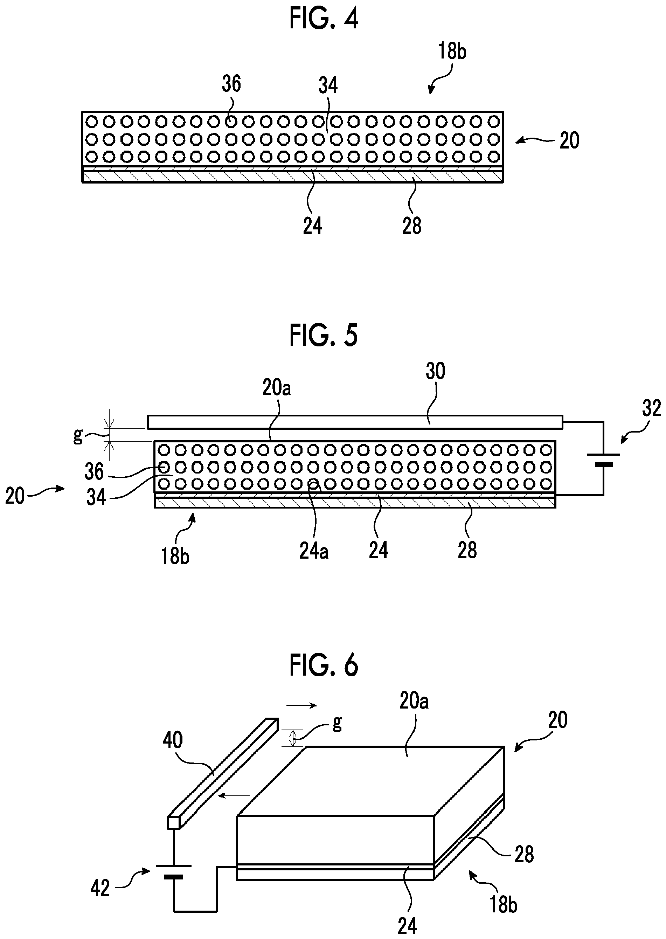

In a case where the sheet-like material 18a is prepared and the coating material is prepared, the coating material is cast (applied) onto the sheet-like material 18a, and the organic solvent is evaporated and dried. Accordingly, as illustrated in Fig. 4, a laminate 18b in which the lower electrode 24 is provided on the lower protective layer 28 and the piezoelectric layer 20 is formed on the lower electrode 24 is produced. The lower electrode 24 refers to an electrode on the base material side in a case where the piezoelectric layer 20 is applied, and does not indicate the vertical positional relationship in the laminate.

A casting method of the coating material is not particularly limited, and all known methods (coating devices) such as a slide coater or a doctor knife are able to be used.

Alternatively, in a case where the viscoelastic material is a material that is able to be heated and melted like cyanoethylated PVA, a melted material may be produced by heating and melting the viscoelastic material and adding and dispersing the piezoelectric particles 36 therein, extruded into a sheet shape on the sheet-like material 18a illustrated in Fig. 3 by extrusion molding or the like, and cooled, thereby producing the laminate 18b in which the lower electrode 24 is provided on the lower protective layer 28 and the piezoelectric layer 20 is formed on the lower electrode 24 as illustrated in Fig. 4.

As described above, in the piezoelectric film 18, in addition to the viscoelastic material such as cyanoethylated PVA, a polymer piezoelectric material such as PVDF may be added to the viscoelastic matrix 34.

In a case where the polymer piezoelectric material is added to the viscoelastic matrix 34, the polymer piezoelectric material added to the coating material may be dissolved. Alternatively, the polymer piezoelectric material to be added may be added to the heated and melted viscoelastic material and may be heated and melted.

After the laminate 18b in which the lower electrode 24 is provided on the lower protective layer 28 and the piezoelectric layer 20 is formed on the lower electrode 24 is produced, the piezoelectric layer 20 is subjected to polarization processing (poling).

A polarization processing method of the piezoelectric layer 20 is not limited, and a known method is able to be used. As a preferable polarization processing method, a method illustrated in Figs. 5 and 6 is exemplified.

In this method, as illustrated in Figs. 5 and 6, for example, an interval g of 1 mm is opened on an upper surface 20a of the piezoelectric layer 20 of the laminate 18b, and a rod-like or wire-like corona electrode 40 which is able to be moved along the upper surface 20a is provided. Then, the corona electrode 40 and the lower electrode 24 are connected to a direct-current power source 42.

Furthermore, a heating unit for heating and holding the laminate 18b, for example, a hot plate, is prepared.

Then, in a state where the piezoelectric layer 20 is heated and held by the heating unit, for example, at a temperature of 100°C, a direct-current voltage of a few kV, for example, 6 kV, is applied between the lower electrode 24 and the corona electrode 40 from the direct-current power source 42, and thus a corona discharge occurs. Furthermore, in a state where the interval g is maintained, the corona electrode 40 is moved (scanned) along the upper surface 20a of the piezoelectric layer 20, and the piezoelectric layer 20 is subjected to the polarization processing.

Accordingly, the piezoelectric layer 20 is polarized in the thickness direction.

In the polarization processing using such corona discharge (hereinafter, also referred to as corona poling processing for convenience), a known rod-like moving unit may be used to move the corona electrode 40.

In addition, in the corona poling processing, a method of moving the corona electrode 40 is not limited. That is, the corona electrode 40 is fixed, a moving mechanism for moving the laminate 18b is provided, and the polarization processing may be performed by moving the laminate 18b. A known moving unit for moving a sheet-like material may be used to move the laminate 18b.

Furthermore, the number of corona electrodes 40 is not limited to one, and the corona poling processing may be performed by using a plurality of corona electrodes 40.

In addition, the polarization processing is not limited to the corona poling processing, and normal electric field poling in which a direct-current electric field is directly applied to an object to be subjected to the polarization processing may also be used. However, in a case where this normal electric field poling is performed, it is necessary that the upper electrode 26 is formed before the polarization processing.

Before the polarization processing, calender processing may be performed to smoothen the surface of the piezoelectric layer 20 using a heating roller or the like. By performing the calender processing, a thermal compression bonding process described below is able to be smoothly performed.

In this way, while the piezoelectric layer 20 of the laminate 18b is subjected to the polarization processing, a sheet-like material 18c is prepared in which the upper electrode 26 is formed on the upper protective layer 30. This sheet-like material 18c may be produced by forming a copper thin film or the like as the upper electrode 26 on the surface of the upper protective layer 30 using vacuum vapor deposition, sputtering, plating, or the like.

Next, as illustrated in Fig. 7, the sheet-like material 18c is laminated on the laminate 18b in which the piezoelectric layer 20 is subjected to the polarization processing while the upper electrode 26 faces the piezoelectric layer 20.

Furthermore, a laminate of the laminate 18b and the sheet-like material 18c is interposed between the upper protective layer 30 and the lower protective layer 28, and is subjected to the thermal compression bonding using a heating press device, a heating roller pair, or the like such that the piezoelectric film 18 is produced.

As will be described later, in the electroacoustic transducer 10 illustrated in Fig. 1, the exciter 14 has a configuration in which the piezoelectric films 18 are laminated and bonded to each other with the bonding layer 19 as a preferable embodiment. Here, in the exciter 14 of the illustrated example, as a preferable embodiment, as indicated by the arrows attached to the piezoelectric layer 20 in Fig. 1, the polarization directions of adjacent piezoelectric films 18 are opposite to each other.

A general laminated ceramic piezoelectric element in which piezoelectric ceramic materials are laminated is subjected to polarization processing after producing a laminate of the piezoelectric ceramic materials. Only common electrodes exist at the interface between the piezoelectric layers, so that the polarization directions of the piezoelectric layers alternate in the lamination direction.

Contrary to this, the piezoelectric films 18 constituting the exciter 14 of the illustrated example can be subjected to polarization processing in the state of the piezoelectric films 18 before lamination. The piezoelectric films 18 are preferably subjected to polarization processing of the piezoelectric layer 20 by corona poling processing before laminating the upper electrode 26 and the upper protective layer 30, as illustrated in Figs. 5 and 6.

Therefore, the exciter 14 can be produced by laminating the piezoelectric films 18 subjected to the polarization processing. Preferably, a long piezoelectric film (large-area piezoelectric film) subjected to the polarization processing is produced and cut into individual piezoelectric films 18, and then the piezoelectric films 18 are laminated to form the exciter 14.

Therefore, in the exciter 14, the polarization directions of adjacent piezoelectric films 18 can be aligned in the lamination direction, or can be alternated as illustrated in Fig. 1.

As illustrated in Fig. 1, as a preferable embodiment, the exciter 14 has a configuration in which a plurality of layers (three layers in the illustrated example) of piezoelectric films 18 are laminated so that the polarization directions of the adjacent piezoelectric films 18 are opposite to each other, and the adjacent piezoelectric films 18 are bonded by the bonding layer 19.

In the present invention, various known bonding layers 19 can be used as long as the adjacent piezoelectric films 18 can be bonded.

Therefore, the bonding layer 19 may be a layer consisting of an adhesive, a layer consisting of a pressure sensitive adhesive, or a layer consisting of a material having characteristics of both an adhesive and a pressure sensitive adhesive, which are described above. In addition, the bonding layer 19 may be formed by applying a bonding agent having fluidity such as a liquid, or may be formed by using a sheet-shaped bonding agent.

Here, for example, the exciter 14 vibrates the vibration plate 12 as described later and generates a sound by stretching and contracting the plurality of laminated piezoelectric films 18. Therefore, in the exciter 14, it is preferable that the stretching and contracting of each piezoelectric film 18 is directly transmitted. In a case where a substance having a viscosity that relieves vibration is present between the piezoelectric films 18, the efficiency of transmitting the stretching and contracting energy of the piezoelectric film 18 is lowered, and the driving efficiency of the exciter 14 is also decreased.

In consideration of this point, the bonding layer 19 is preferably an adhesive layer consisting of an adhesive with which a solid and hard bonding layer 19 is obtained, rather than a pressure sensitive adhesive layer consisting of a pressure sensitive adhesive. As a more preferable bonding layer 19, specifically, a bonding layer consisting of a thermoplastic type adhesive such as a polyester-based adhesive or a styrene-butadiene rubber (SBR)-based adhesive is suitably exemplified.

Adhesion, unlike pressure sensitive adhesion, is useful in a case where a high adhesion temperature is required. Furthermore, the thermoplastic type adhesive has "relatively low temperature, short time, and strong adhesion" and is suitable.

In the exciter 14, the thickness of the bonding layer 19 is not limited, and a thickness capable of exhibiting sufficient bonding force may be appropriately set depending on the forming material of the bonding layer 19.

Here, in the exciter 14 of the illustrated example, the thinner the bonding layer 19, the higher the effect of transmitting the stretching and contracting energy (vibration energy) of the piezoelectric layer 20, and the higher the energy efficiency. In addition, in a case where the bonding layer 19 is thick and has high rigidity, there is a possibility that the stretching and contracting of the piezoelectric film 18 may be constrained.

In consideration of this point, the bonding layer 19 is preferably thinner than the piezoelectric layer 20. That is, in the exciter 14, the bonding layer 19 is preferably hard and thin. Specifically, the thickness of the bonding layer 19 is preferably 0.1 to 50 µm, more preferably 0.1 to 30 µm, and even more preferably 0.1 to 10 µm in terms of thickness after bonding.

Furthermore, as will be described later, in the exciter 14 of the illustrated example, since the polarization directions of the adjacent piezoelectric films are opposite to each other and there is no concern that the adjacent piezoelectric films 18 may be short-circuited, the bonding layer 19 can be made thin.

In the exciter 14 of the illustrated example, in a case where the spring constant (thickness × Young's modulus) of the bonding layer 19 is high, there is a possibility that the stretching and contracting of the piezoelectric film 18 may be constrained. Therefore, the spring constant of the bonding layer 19 is preferably equal to or less than the spring constant of the piezoelectric film 18.

Specifically, the product of the thickness of the bonding layer 19 and the storage elastic modulus (E') at a frequency of 1 Hz according to the dynamic viscoelasticity measurement is preferably 2.0 × 10⁶ N/m or less at 0°C and 1.0 × 10⁶ N/m or less at 50°C.

It is preferable that the internal loss of the bonding layer at a frequency of 1 Hz according to the dynamic viscoelasticity measurement is 1.0 or less at 25°C in the case of the bonding layer 19 consisting of a pressure sensitive adhesive, and is 0.1 or less at 25°C in the case of the bonding layer 19 consisting of an adhesive.

In the exciter 14 included in the electroacoustic transducer 10, the bonding layer 19 is provided as a preferable embodiment and is not an essential constituent element.

Therefore, in a case where the exciter included in the electroacoustic transducer 10 of the embodiment of the present invention is a laminate of the piezoelectric films 18, the exciter may be configured by laminating and closely attaching the piezoelectric films 18 constituting the exciter using a known pressure bonding unit, a fastening unit, a fixing unit, or the like without having the bonding layer 19. For example, in a case where the piezoelectric film 18 is rectangular, the exciter may be configured by fastening four corners with members such as bolts and nuts, or the exciter may be configured by fastening four corners to a center portion with the same members. Alternatively, the exciter may be configured by laminating the piezoelectric films 18 and thereafter bonding the peripheral portion (end surface) with a pressure sensitive adhesive tape to fix the laminated piezoelectric films 18.

However, in this case, in a case where a driving voltage is applied from the power source PS, the individual piezoelectric films 18 stretch and contract independently, and in some cases, layers of the piezoelectric films 18 bend in opposite directions and form a void. As described above, in a case where the individual piezoelectric films 18 stretch and contract independently, the driving efficiency of the exciter decreases, the degree of stretching and contracting of the exciter as a whole decreases, and there is a possibility that an abutting vibration plate or the like cannot sufficiently vibrate. In particular, in a case where the layers of the piezoelectric films 18 bend in the opposite directions and form a void, the driving efficiency of the exciter is greatly decreased.

In consideration of this point, it is preferable that the exciter included in the electroacoustic transducer of the embodiment of the present invention has the bonding layer 19 for bonding adjacent piezoelectric films 18 to each other, as in the exciter 14 of the illustrated example.

In the electroacoustic transducer 10 of the embodiment of the present invention, the product of the thickness of the exciter 14 and the storage elastic modulus at a frequency of 1 Hz and 25°C according to the dynamic viscoelasticity measurement is at most three times the product of the thickness of the vibration plate 12 and the Young's modulus. That is, in the exciter 14, the spring constant with respect to a slow movement at room temperature is at most three times that of the vibration plate 12.

As is clear from the above description, the product of the thickness of the exciter 14 and the storage elastic modulus at a frequency of 1 Hz and 25°C according to the dynamic viscoelasticity measurement greatly affects not only the thickness of the bonding layer 19 but also the physical properties of the bonding layer 19 such as the storage elastic modulus.

On the other hand, the product of the thickness of the vibration plate 12 and the Young's modulus, that is, the spring constant of the vibration plate greatly affects not only the thickness of the vibration plate but also the physical properties of the vibration plate.

Therefore, in the electroacoustic transducer 10 of the embodiment of the present invention, it is preferable that the thickness and material (type) of the bonding layer 19 and the thickness and material of the vibration plate 12 are appropriately selected so that the spring constant of the exciter 14 is at most three times the spring constant of the vibration plate 12 with respect to a slow movement at room temperature. In other words, in the electroacoustic transducer 10 of the embodiment of the present invention, by appropriately selecting the thickness and material of the bonding layer 19 and the thickness and material of the vibration plate 12 depending on the characteristics of the piezoelectric film 18 and the like, the spring constant of the exciter 14 can be suitably at most three times the spring constant of the vibration plate 12 with respect to a slow movement at room temperature.

As illustrated in Fig. 1, in the electroacoustic transducer 10, the power source Ps for applying the driving voltage for stretching and contracting the piezoelectric film 18 is connected to the lower electrode 24 and the upper electrode 26 of each of the piezoelectric films 18.

The power source PS is not limited and may be a direct-current power source or an alternating-current power source. In addition, as for the driving voltage, a driving voltage capable of appropriately driving each of the piezoelectric films 18 may be appropriately set according to the thickness, forming material, and the like of the piezoelectric layer 20 of each piezoelectric film 18.

As will be described later, in the exciter 14 of the illustrated example, the polarization directions of the adjacent piezoelectric films 18 are opposite to each other. Therefore, in the adjacent piezoelectric films 18, the lower electrodes 24 face each other and the upper electrodes 26 face each other. Therefore, the power source PS always supplies power of the same polarity to the facing electrodes regardless of whether the power source PS is an alternating-current power source or a direct-current power source. For example, in the exciter 14 illustrated in Fig. 1, the upper electrode 26 of the piezoelectric film 18 in the lowermost layer in the figure and the upper electrode 26 of the piezoelectric film 18 in the second layer (middle layer) are always supplied with power of the same polarity, and the lower electrode 24 of the piezoelectric film 18 in the second layer and the lower electrode 24 of the piezoelectric film 18 in the uppermost layer in the figure are always supplied with power of the same polarity.

A method of leading out an electrode from the lower electrode 24 and the upper electrode 26 is not limited, and various known methods can be used.

As an example, a method of leading out an electrode to the outside by connecting a conductor such as a copper foil to the lower electrode 24 and the upper electrode 26, and a method of leading out an electrode to the outside by forming through-holes in the lower protective layer 28 and the upper protective layer 30 by a laser or the like and filling the through-holes with a conductive material are exemplified.

As a suitable method of leading out an electrode, the method described in JP2014-209724A, the method described in JP2016-015354A, and the like are exemplified.

As described above, in the electroacoustic transducer 10 of the illustrated example, the exciter 14 has a configuration in which a plurality of layers of piezoelectric films 18 are laminated and adjacent piezoelectric films 18 are bonded to each other by the bonding layer 19.

In addition, in the exciter 14 of the illustrated example, the polarization directions of the adjacent piezoelectric films 18 are opposite to each other. That is, in the exciter 14 of the illustrated example, the piezoelectric films 18 are laminated so that the polarization directions alternate in the lamination directions (thickness directions) of the piezoelectric films 18.

As described above, the electroacoustic transducer 10 of the embodiment of the present invention illustrated in Fig. 1 is configured by bonding the vibration plate 12 to the exciter 14 by the bonding layer 16.

The exciter 14 is a laminate of a plurality of layers of piezoelectric films 18. The piezoelectric layer 20 included in the piezoelectric film 18 is formed by dispersing the piezoelectric particles 36 in the viscoelastic matrix 34. In addition, the lower electrode 24 and the upper electrode 26 are provided so as to sandwich the piezoelectric layer 20 therebetween in the thickness direction.

In a case where a voltage is applied to the lower electrode 24 and the upper electrode 26 of the piezoelectric film 18 having the piezoelectric layer 20, the piezoelectric particles 36 stretch and contract in the polarization direction according to the applied voltage. As a result, the piezoelectric film 18 (piezoelectric layer 20) contracts in the thickness direction. At the same time, the piezoelectric film 18 stretches and contracts in an in-plane direction due to the Poisson's ratio.

The degree of stretching and contracting is about 0.01% to 0.1%.

As described above, the thickness of the piezoelectric layer 20 is preferably about 10 to 300 µm. Therefore, the degree of stretching and contracting in the thickness direction is as very small as about 0.3 µm at the maximum.

Contrary to this, the piezoelectric film 18, that is, the piezoelectric layer 20, has a size much larger than the thickness in the surface direction. Therefore, for example, in a case where the length of the piezoelectric film 18 is 20 cm, the piezoelectric film 18 stretches and contracts by a maximum of about 0.2 mm by the application of a voltage.

As described above, the vibration plate 12 is bonded to the exciter 14 by the bonding layer 16. Therefore, the stretching and contracting of the piezoelectric film 18 causes the vibration plate 12 to bend, and as a result, the vibration plate 12 vibrates in the thickness direction.

The vibration plate 12 generates a sound due to the vibration in the thickness direction. That is, the vibration plate 12 vibrates according to the magnitude of the voltage (driving voltage) applied to the piezoelectric film 18, and generates a sound according to the driving voltage applied to the piezoelectric film 18.

Here, it is known that in a case where a general piezoelectric film consisting of a polymer material such as PVDF is stretched in a uniaxial direction after being subjected to polarization processing, the molecular chains are oriented with respect to the stretching direction, and as a result, high piezoelectric properties are obtained in the stretching direction. Therefore, a general piezoelectric film has in-plane anisotropy in the piezoelectric properties, and has anisotropy in the amount of stretching and contracting in the surface direction in a case where a voltage is applied.

Contrary to this, in the electroacoustic transducer 10 of the illustrated example, the piezoelectric film 18 which is included in the exciter 14 and consists of a polymer-based piezoelectric composite material in which the piezoelectric particles 36 are dispersed in the viscoelastic matrix 34 achieves high piezoelectric properties without stretching after the polarization processing. Therefore, the piezoelectric film 18 has no in-plane anisotropy in the piezoelectric properties, and stretches and contracts isotropically in all directions in the in-plane direction. That is, in the electroacoustic transducer 10 of the illustrated example, the piezoelectric film 18 included in the exciter 14 stretches and contracts isotropically and two-dimensionally. According to the exciter 14 in which such piezoelectric films 18 that stretch and contract isotropically and two-dimensionally are laminated, compared to a case where general piezoelectric films made of PVDF or the like that stretch and contract greatly in only one direction are laminated, the vibration plate 12 can be vibrated with a large force. As a result, the vibration plate 12 can generate a louder and more beautiful sound.

As described above, the exciter 14 of the illustrated example is a laminate of a plurality of such piezoelectric films 18. In the exciter 14 of the illustrated example, as a preferable embodiment, adjacent piezoelectric films 18 are further bonded to each other by the bonding layer 19. Therefore, even though the rigidity of each piezoelectric film 18 is low and the stretching and contracting force thereof is small, the rigidity is increased by laminating the piezoelectric films 18, and the stretching and contracting force as the exciter 14 is increased. As a result, in the exciter 14, even in a case where the vibration plate 12 has a certain degree of rigidity, the vibration plate 12 is sufficiently bent with a large force and the vibration plate 12 can be sufficiently vibrated in the thickness direction, whereby the vibration plate 12 can generate a sound.

In addition, the thicker the piezoelectric layer 20, the larger the stretching and contracting force of the piezoelectric film 18, but the larger the driving voltage required for stretching and contracting by the same amount. Here, as described above, in the exciter 14, a preferable thickness of the piezoelectric layer 20 is about 300 µm at the maximum. Therefore, even in a case where the voltage applied to each piezoelectric film 18 is small, it is possible to sufficiently stretch and contract the piezoelectric films 18.

Here, in the electroacoustic transducer 10 of the illustrated example, as described above, in the exciter 14, the polarization directions of the piezoelectric layers 20 of the adjacent piezoelectric films 18 are opposite to each other.

In the piezoelectric film 18, the polarity of the voltage applied to the piezoelectric layer 20 depends on the polarization direction. Therefore, regarding the polarity of the applied voltage, in the polarization directions indicated by the arrows in Fig. 1, the polarity of the electrode on the side in a direction in which the arrows are directed (the downstream side of the arrows) and the polarity of the electrode on the opposite side (the upstream side of the arrows) are coincident with each other in all the piezoelectric films 18.

In the illustrated example, the electrode on the side in the direction in which the arrows indicating the polarization direction are directed is the lower electrode 24, the electrode on the opposite side is the upper electrode 26, and the polarities of the upper electrode 26 and the lower electrode 24 are the same in all the piezoelectric films 18.

Therefore, in the exciter 14 in which the polarization directions of the piezoelectric layers 20 of the adjacent piezoelectric films 18 are opposite to each other, in the adjacent piezoelectric films 18, the upper electrodes 26 face each other on one surface, and the lower electrodes face each other on the other surface. Therefore, in the exciter 14 of the illustrated example, even in a case where the electrodes of the adjacent piezoelectric films 18 come into contact with each other, there is no risk of a short circuit.

As described above, in order to stretch and contract the exciter 14 with good energy efficiency, it is preferable to make the bonding layer 19 thin so that the bonding layer 19 does not interfere with the stretching and contracting of the piezoelectric layer 20.

Contrary to this, in the exciter 14 of the illustrated example in which there is no risk of a short circuit even in a case where the electrodes of the adjacent piezoelectric films 18 come into contact with each other, the bonding layer 19 may be omitted. In addition, even in a case where the bonding layer 19 is provided as a preferable embodiment, the bonding layer 19 can be made extremely thin as long as a required bonding force can be obtained.

Therefore, the exciter 14 can be stretched and contracted with high energy efficiency.

As described above, in the piezoelectric film 18, the absolute amount of stretching and contracting of the piezoelectric layer 20 in the thickness direction is very small, and the stretching and contracting of the piezoelectric film 18 is substantially only in the surface direction.

Therefore, even in a case where the polarization directions of the laminated piezoelectric films 18 are opposite to each other, all the piezoelectric films 18 stretch and contract in the same direction as long as the polarities of the voltages applied to the lower electrode 24 and the upper electrode 26 are correct.

In the exciter 14, the polarization direction of the piezoelectric film 18 may be detected by a d33 meter or the like.

Alternatively, the polarization direction of the piezoelectric film 18 may be known from the processing conditions of the corona poling processing described above.

In the exciter 14 of the illustrated example, preferably, as described above, a long (large-area) piezoelectric film is produced, and the long piezoelectric film is cut into individual piezoelectric films 18. Therefore, in this case, the plurality of piezoelectric films 18 constituting the exciter 14 are all the same.

However, the present invention is not limited thereto. That is, in the electroacoustic transducer of the embodiment of the present invention, the exciter can use various configuration such as a configuration in which piezoelectric films having different layer configurations, such as the piezoelectric film having the lower protective layer 28 and the upper protective layer 30 and a piezoelectric film having no lower protective layer and no upper protective layer, are laminated, a configuration in which piezoelectric films in which the thicknesses of the piezoelectric layers 20 are different are laminated, and the like.

In the electroacoustic transducer 10 illustrated in Fig. 1, the exciter 14 is formed by laminating a plurality of piezoelectric films 18 so that the polarization directions of adjacent piezoelectric films are opposite to each other, and bonding the adjacent piezoelectric films 18 by the bonding layer 19, as a preferable embodiment.

In the electroacoustic transducer of the embodiment of the present invention, the exciter formed by laminating the piezoelectric films is not limited thereto, and various configurations can be used.

Fig. 8 illustrates an example thereof. Since the exciter 56 illustrated in Fig. 8 uses a plurality of the same members of the above-mentioned exciter 14, the same members are designated by the same reference numerals, and the description will be given mainly to different parts.

The exciter 56 illustrated in Fig. 8 is a more preferable embodiment of the exciter used in the electroacoustic transducer of the embodiment of the present invention, in which a long piezoelectric film 18L is folded back, for example, once or more, or preferably a plurality of times in the longitudinal direction, such that a plurality of layers of the piezoelectric film 18L are laminated. In addition, similarly to the exciter 14 illustrated in Fig. 1 and the like described above, in the exciter 56 illustrated in Fig. 8, as a preferable embodiment, the piezoelectric film 18L laminated by folding-back is bonded by the bonding layer 19.

By folding back and laminating one sheet of the long piezoelectric film 18L polarized in the thickness direction, the polarization directions of the piezoelectric film 18L adjacent (facing) in the lamination direction become opposite directions as indicated by the arrows in Fig. 8.

According to this configuration, the exciter 56 can be configured with only one sheet of the long piezoelectric film 18L. Furthermore, according to this configuration, only one power source PS for applying the driving voltage is required, and moreover, an electrode may be led out from the piezoelectric film 18L at one place.

Therefore, according to the exciter 56 illustrated in Fig. 8, the number of components can be reduced, the configuration can be simplified, the reliability of the piezoelectric element (module) can be improved, and a further reduction in cost can be achieved.

Like the exciter 56 illustrated in Fig. 8, in the exciter 56 in which the long piezoelectric film 18L is folded back, it is preferable to insert a core rod 58 into the folded-back portion of the piezoelectric film 18L while abutting the piezoelectric film 18L.

As described above, the lower electrode 24 and the upper electrode 26 of the piezoelectric film 18L are formed of a metal vapor deposition film or the like. In a case where the metal vapor deposition film is bent at an acute angle, cracks and the like are likely to occur, and there is a possibility that the electrode may be broken. That is, in the exciter 56 illustrated in Fig. 8, cracks or the like are likely to occur in the electrodes inside the bent portion.

For this, in the exciter 56 in which the long piezoelectric film 18L is folded back, by inserting the core rod 58 into the folded-back portion of the piezoelectric film 18L, the lower electrode 24 and the upper electrode 26 are prevented from being bent. Therefore, it is possible to preferably prevent the occurrence of breakage.

In the electroacoustic transducer of the embodiment of the present invention, the exciter may use the bonding layer 19 having conductivity. In particular, in the exciter 56 in which one sheet of the long piezoelectric film 18L is folded back and laminated as illustrated in Fig. 8, the bonding layer 19 having conductivity is preferably used.

In the exciter in which the polarization directions of the adjacent piezoelectric film 18 are opposite to each other as illustrated in Figs. 1 and 8, in the laminated piezoelectric film 18, electric power having the same polarity is supplied to the facing electrodes. Therefore, a short circuit does not occur between the facing electrodes.

On the other hand, as described above, in the exciter 56 in which the piezoelectric film 18L is folded back and laminated, the electrode is likely to be broken inside the bent portion that is folded back at an acute angle.

Therefore, by bonding the laminated piezoelectric film 18L by the bonding layer 19 having conductivity, even in a case where the electrode is broken inside the bent portion, electrical conduction can be secured by the bonding layer 19, which prevents breakage and significantly improves the reliability of the exciter 56.

Here, the piezoelectric film 18L forming the exciter 56 preferably has the lower protective layer 28 and the upper protective layer 30 so that the lower electrode 24 and the upper electrode 26 face each other so as to interpose the laminate therebetween as illustrated in Fig. 2.

In this case, even in a case where the bonding layer 19 having conductivity is used, the conductivity cannot be secured. Therefore, in a case where the piezoelectric film 18L has a protective layer, through-holes may be provided in the lower protective layer 28 and the upper protective layer 30 in regions where the lower electrodes 24 face each other and the upper electrodes 26 face each other in the laminated piezoelectric film 18L, and the bonding layer 19 having conductivity may be brought into contact with the lower electrode 24 and the upper electrode 26. Preferably, the through-holes formed in the lower protective layer 28 and the upper protective layer 30 are closed with a silver paste or a conductive bonding agent, and the adjacent piezoelectric film 18L is bonded thereto with the bonding layer 19 having conductivity.

In this case, the through-holes of the lower protective layer 28 and the upper protective layer 30 may be formed by removal of the protective layers through laser processing, solvent etching, mechanical polishing, or the like.

The number of through-holes of the lower protective layer 28 and the upper protective layer 30 may be one or more in the regions where the lower electrodes 24 face each other and the upper electrodes 26 face each other in the laminated piezoelectric film 18L, preferably outside the bent portion of the piezoelectric film 18L. Alternatively, the through-holes of the lower protective layer 28 and the upper protective layer 30 may be formed regularly or irregularly on the entire surface of the lower protective layer 28 and the upper protective layer 30.

The bonding layer 19 having conductivity is not limited, and various known bonding layers can be used.

In the exciter of the above electroacoustic transducer, the polarization direction of the laminated piezoelectric film 18 is opposite to that of the adjacent piezoelectric film 18, but the present invention is not limited thereto.

That is, in the electroacoustic transducer of the embodiment of the present invention, in the exciter in which the piezoelectric films 18 are laminated, the polarization directions of the piezoelectric film 18 (piezoelectric layers 20) may be all the same as in the exciter 60 illustrated in Fig. 9.

As illustrated in Fig. 9, in the exciter 60 in which the polarization directions of the laminated piezoelectric films 18 are all the same, the lower electrode 24 and the upper electrode 26 face each other between the adjacent piezoelectric films 18. Therefore, in a case where the bonding layer 19 is not made sufficiently thick, the lower electrodes 24 and the upper electrodes 26 of the adjacent piezoelectric films 18 may come into contact with each other at the outer end portion of the bonding layer 19 in the surface direction, and there is a risk of a short circuit.

Therefore, as illustrated in Fig. 9, in the exciter 60 in which the polarization directions of the laminated piezoelectric films 18 are all the same, the bonding layer 19 cannot be made thin, and the energy efficiency is inferior to that of the exciters illustrated in Figs. 1 and 8.

While the electroacoustic transducer of the embodiment of the present invention has been described in detail, the present invention is not limited to the examples described above, and various improvements or modifications may be naturally performed within a range not deviating from the gist of the present invention.

### Examples

Hereinafter, the present invention will be described in more detail with reference to specific examples of the present invention.

### [Production of Piezoelectric Film]

A piezoelectric film as illustrated in Fig. 2 was produced by the method illustrated in Figs. 3 to 7 described above.

First, cyanoethylated PVA (CR-V manufactured by Shin-Etsu Chemical Co., Ltd.) was dissolved in methyl ethyl ketone (MEK) at the following compositional ratio. Thereafter, PZT particles were added to this solution at the following compositional ratio, and were dispersed by using a propeller mixer (rotation speed 2000 rpm), and thus a coating material for forming a piezoelectric layer was prepared.
- PZT Particles 1000 parts by mass
- Cyanoethylated PVA 100 parts by mass
- MEK 600 parts by mass

In addition, as the PZT particles, PZT particles obtained by sintering commercially available PZT raw material powder at 1000°C to 1200°C and thereafter crushing and classifying the resultant so as to have an average particle diameter of 3.5 µm were used.

On the other hand, a sheet-like material in which a copper thin film having a thickness of 0.1 µm was vacuum vapor deposited on a long PET film having a width of 23 cm and a thickness of 4 µm as illustrated in Fig. 3 was prepared. That is, in this example, an upper electrode and a lower electrode are copper vapor deposition thin films having a thickness of 0.1 m, and an upper protective layer and a lower protective layer are PET films having a thickness of 4 µm.

In order to obtain good handleability during the process, as the PET film, a film with a separator (temporary support PET) having a thickness of 50 µm attached thereto was used, and the separator of each protective layer was removed after the thermal compression bonding of thin film electrodes and the protective layers.

The coating material for forming the piezoelectric layer prepared as described above was applied onto the lower electrode (copper vapor deposition thin film)of the sheet-like material by using a slide coater. The coating material was applied such that the film thickness of the coating film after being dried was 40 µm.

Next, a material in which the coating material was applied onto the sheet-like material was heated and dried in an oven at 120°C such that MEK was evaporated. Accordingly, as illustrated in Fig. 4, a laminate was produced in which the lower electrode made of copper was provided on the lower protective layer made of PET and the piezoelectric layer having a thickness of 40 µm was formed thereon.

The piezoelectric layer of the laminate was subjected to polarization processing in a thickness direction by corona poling illustrated in Figs. 5 and 6 described above. Furthermore, the polarization processing was performed by setting the temperature of the piezoelectric layer to 100°C, and applying a direct-current voltage of 6 kV between the lower electrode and a corona electrode so as to cause corona discharge to occur.

On the laminate subjected to the polarization processing, the same sheet-like material obtained by vacuum vapor depositing a copper thin film on a PET film was laminated as illustrated in Fig. 7.

Next, the laminate of the laminate and the sheet-like material was subjected to thermal compression bonding at 120°C using a laminator device to adhere the piezoelectric layer to the upper electrode and the lower electrode, whereby the piezoelectric layer was interposed between the upper electrode and the lower electrode and the laminate was interposed between the upper protective layer and the lower protective layer.

Accordingly, a piezoelectric film as shown in Fig. 2 was produced.

### [Example 1]

As conceptually illustrated in Fig. 10, the produced piezoelectric film was cut into 5 × 100 cm to produce a long piezoelectric film F.

At one end portion in the longitudinal direction, only a predetermined protective layer was peeled off to expose the electrode surface, and a copper foil C for leading out an electrode was laminated on the electrode surface to obtain a lead-out electrode.

The resultant was laminated on the piezoelectric layer, and the sheet-like material was bonded as described above.

Next, a heat-adhesive sheet (LIOELM TSU41SI-25DL manufactured by Toyochem Co., Ltd., thickness 25 µm) was cut into about 5 × 20 cm to obtain a heat-adhesive sheet A.

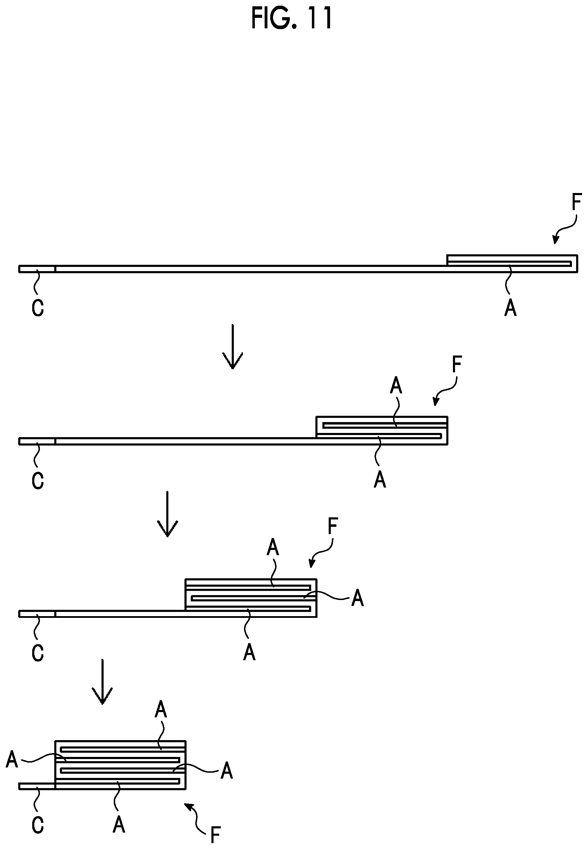

Next, as conceptually illustrated in Figs. 10 and 11, the end portion of the piezoelectric film F opposite to the copper foil was folded back so as to cause the heat-adhesive sheet A to be interposed therebetween, and adhered with a heat press machine.

As illustrated in Fig. 11, such an operation of folding back the piezoelectric film F, interposing the heat-adhesive sheet A therebetween, and adhering the piezoelectric film F with a press machine was repeated by inverting the piezoelectric film F in the longitudinal direction. Accordingly, an exciter as shown in the lower part of Fig. 11, in which the piezoelectric film F was folded back four times and laminated in five layers, was produced.

The thickness of the produced exciter was 350 µm.

A PET film having a thickness of 300 µm was prepared.

This PET film was cut into 30 × 20 cm to obtain a vibration plate.

For the produced exciter and vibration plate, a strip-shaped test piece of 1 × 4 cm was produced and dynamic viscoelasticity measurement was performed to measure the loss tangent (tanδ) at a frequency of 1 Hz, the loss tangent at a frequency of 1 kHz, the storage elastic modulus (E') at a frequency of 1 Hz and 25°C, and the storage elastic modulus at a frequency of 1 kHz and 25°C.

In a case where the response of the material is sufficiently elastic, the storage elastic modulus is consistent with Young's modulus. Therefore, for the vibration plate, the storage elastic modulus of the vibration plate at a frequency of 1 Hz and 25°C was taken as the Young's modulus of the vibration plate from the obtained measurement data.

The measurement was performed using a dynamic viscoelasticity measuring machine (DMS6100 viscoelasticity spectrometer manufactured by SII NanoTechnology Inc.).

The measurement conditions were set such that the measurement temperature range was -20°C to 100°C and the temperature rising rate was 2 °C/min (in a nitrogen atmosphere). The measurement frequencies were set to 0.1 Hz, 0.2 Hz, 0.5 Hz, 1 Hz, 2 Hz, 5 Hz, 10 Hz, and 20 Hz. The measurement mode was set to a tensile measurement. Furthermore, the chuck-to-chuck distance was set to 20 mm.

As a result, in the exciter, the loss tangent at a frequency of 1 Hz had a maximal value (maximum value) of 0.2 at 18°C in a temperature range of 0°C to 50°C. The loss tangent of the exciter at a frequency of 1 kHz and 25°C was 0.07.

The storage elastic modulus of the exciter at a frequency of 1 Hz and 25°C was 5.1 GN/m². As described above, the thickness of the exciter is 350 µm. Therefore, the product of the thickness of the exciter and the storage elastic modulus at a frequency of 1 Hz and 25°C is 350 µm × 5.1 GN/m², which is 1.8 MN/m.

Furthermore, in a master curve obtained from the dynamic viscoelasticity measurement of the exciter, the storage elastic modulus of the exciter at a frequency of 1 kHz and 25°C was 15.4 GN/m². The thickness of the exciter is 350 µm. Therefore, the product of the thickness of the exciter and the storage elastic modulus at a frequency of 1 kHz and 25°C is 350 µm × 15.4 GN/m², which is 5.4 MN/m.

On the other hand, the Young's modulus of the vibration plate (PET film having a thickness of 300 µm) was 5 GPa.

Since the thickness of the vibration plate is 300 µm, the product of the thickness of the vibration plate and the Young's modulus, that is, the spring constant of the vibration plate is 1.5 MN/m.

Therefore, three times the spring constant of the vibration plate is 4.5 MN/m. In addition, 0.3 times the spring constant of the vibration plate is 0.45 MN/m.

An exciter was bonded to the center of a vibration plate of 30 × 20 cm using a heat-adhesive sheet (LIOELM TSU41SI-25DL manufactured by Toyochem Co., Ltd., thickness 25 µm) and a heat press machine, whereby an electroacoustic transducer was produced.

### [Comparative Example 1]

A PET film having a thickness of 50 µm was prepared. This PET film was cut into 30 × 20 cm to obtain a vibration plate.

The Young's modulus of the vibration plate was measured in the same manner as in Example 1. As a result, the Young's modulus of the vibration plate was 5 GPa.

Since the thickness of the vibration plate is 50 µm, the product of the thickness of the vibration plate and the Young's modulus, that is, the spring constant of the vibration plate is 0.25 MN/m. Therefore, three times the spring constant of the vibration plate is 0.75 MN/m.

An electroacoustic transducer was produced in the same manner as in Example 1 except that this vibration plate was used.

### [Comparative Example 2]

An exciter was produced in the same manner as in Example 1 except that the heat-adhesive sheet A was changed to FB-ML4 (thickness 70 µm plate) manufactured by Nitto Shinko Corporation. The thickness of the produced exciter was 530 µm.

For the produced exciter, the maximal value of the loss tangent at a frequency of 1 Hz in a range of 0°C to 50°C and the storage elastic modulus at a frequency of 1 Hz and 25°C were measured in the same manner as in Example 1.

As a result, in the exciter, the loss tangent at a frequency of 1 Hz had a maximal value (maximum value) of 0.07 at 15°C in the temperature range of 0°C to 50°C.

In addition, the storage elastic modulus at a frequency of 1 Hz and 25°C was 4.7 GN/m². As described above, the thickness of the exciter is 530 µm. Therefore, the product of the thickness of the exciter and the storage elastic modulus at a frequency of 1 Hz and 25°C is 530 µm × 4.7 GN/m², which is 2.5 MN/m.

An electroacoustic transducer was produced in the same manner as in Example 1 except that this exciter was used.

### [Comparative Example 3]

An electroacoustic transducer was produced in the same manner as in Example 1 using the exciter of Comparative Example 2 and the vibration plate of Comparative Example 1.

### [Example 2]

A PET film having a thickness of 4000 µm was prepared. This PET film was cut into 30 × 20 cm to obtain a vibration plate.

The Young's modulus of the vibration plate was measured in the same manner as in Example 1. As a result, the Young's modulus of the vibration plate was 5 GPa.

Since the thickness of the vibration plate is 4000 µm, the product of the thickness of the vibration plate and the Young's modulus, that is, the spring constant of the vibration plate is 20 MN/m. Therefore, three times the spring constant of the vibration plate is 60 MN/m. In addition, 0.3 times the spring constant of the vibration plate is 6MN/m.

An electroacoustic transducer was produced in the same manner as in Example 1 except that this vibration plate was used.

### [Evaluation]

The flexibility of the produced electroacoustic transducer was evaluated as follows.

Using an iron round bar, a bending test of folding back the electroacoustic transducer by 180° so that the center portion of the vibration plate had a radius of curvature of 5 cm was performed 10,000 times.

A case where peeling had not occurred from any interface even after performing the bending test 10,000 times was evaluated as A.

A case where peeling had occurred from any interface while performing the bending test 1000 to 9999 times was evaluated as B.

A case where peeling had occurred from any interface while performing the bending test up to 999 times was evaluated as C.

In addition, regarding the electroacoustic transducers of Examples 1 and 2, the sound pressure was also measured.

The sound pressure was measured by applying a sine wave to the electroacoustic transducer and disposing a measurement microphone at a location 1 m away from the center of the vibration plate in a direction perpendicular to the surface of the vibration plate.

The results are shown in the table below.

**[Table 1]**

| | Exciter | | | | | | | | Vibration plate | | Evaluation | |
|---|---|---|---|---|---|---|---|---|---|---|---|---|
| | Loss tangent | | | Thickness [µm] | Storage elastic modulus (25°C) | | Thickness ^{∗} storage elastic modulus | | Thickness [µm] | Spring constant [MN/m] | Flexibility | Sound pressure [dB] |
| | Maximal at 1 Hz, 0°C to 50°C | | 1 kHz, 25°C | | [GN/m²] | | [MN/m] | | | | | |
| | Temperature [°C] | Maximal value | | | 1 Hz | 1 kHz | 1 Hz | 1 kHz | | | | |
| Example 1 | 18 | 0.2 | 0.07 | 350 | 5.1 | 15.4 | 1.8 | 5.4 | 300 | 1.5 | A | 85 |
| Comparative Example 1 | 18 | 0.2 | - | 350 | 5.1 | - | 1.8 | - | 50 | 0.25 | B | - |
| Comparative Example 2 | 15 | 0.07 | - | 530 | 4.7 | - | 2.5 | - | 300 | 1.5 | B | - |
| Comparative Example 3 | 15 | 0.07 | - | 530 | 4.7 | - | 2.5 | - | 50 | 0.25 | C | - |
| Comparative Example 2 | 18 | 0.2 | 0.07 | 350 | 5.1 | 15.4 | 1.8 | 5.4 | 4000 | 20 | A | 75 |

| | | | | | | | | | | | | |
|---|---|---|---|---|---|---|---|---|---|---|---|---|
| The Young s modulus of vibration plate is 5 GN/m² in total. The spring constant of the vibration plate is thickness × Young's modulus (storage elastic modulus). | | | | | | | | | | | | |

As shown in the above table, the electroacoustic transducer of the embodiment of the present invention, in which the loss tangent of the exciter at a frequency of 1 Hz has a maximal value in a temperature range of 0°C to 50°C, and this maximal value is 0.08 or more, and furthermore, the product of the thickness of the exciter and the storage elastic modulus at a frequency of 1 Hz and 25°C is at most three times the spring constant (thickness × Young's modulus) of the vibration plate, has good flexibility.

Contrary to this, in Comparative Example 1 in which the product of the thickness of the exciter and the storage elastic modulus at a frequency of 1 Hz and 25°C exceeds three times the spring constant of the vibration plate, and in Comparative Example 2 in which the loss tangent of the exciter at a frequency of 1 Hz has a maximal value in a temperature range of 0°C to 50°C but the maximal value is less than 0.08, the flexibility is inferior.

Furthermore, in Comparative Example 3 in which the loss tangent of the exciter at a frequency of 1 Hz has a maximal value in a temperature range of 0°C to 50°C, but this maximal value is less than 0.08, and the product of the thickness of the exciter and the storage elastic modulus at a frequency of 1 Hz and 25°C exceeds three times the spring constant of the vibration plate, the flexibility is very poor.

In addition, in Example 1 in which the product of the thickness of the exciter and the storage elastic modulus of the exciter at a frequency of 1 kHz and 25°C is at least 0.3 times the spring constant of the vibration plate, and the loss tangent of the exciter at a frequency of 1 kHz and 25°C is less than 0.08, a high sound pressure is obtained and the acoustic properties are also excellent.

On the other hand, in Example 4 in which the loss tangent of the exciter at a frequency of 1 kHz and 25 ° C is less than 0.08, but the product of the thickness of the exciter and the storage elastic modulus of the exciter at a frequency of 1 kHz and 25°C is less than 0.3 times the spring constant of the vibration plate, the sound pressure is slightly lower than that of Example 1.

As another example and comparative example, a similar electroacoustic transducer was produced using a cut sheet-shaped piezoelectric film instead of folding back a long piezoelectric film.

That is, five piezoelectric films cut into 5 × 20 cm were cut out from the produced piezoelectric film. An exciter in which five piezoelectric films were laminated was produced by laminating and adhering five piezoelectric films with an adhesive sheet interposed therebetween, in the same manner as in Examples 1 and 2 and Comparative Examples 1 to 3.

An electroacoustic transducer was produced by bonding a vibration plate in the same manner as in Examples 1 and 2 and Comparative Examples 1 to 3 except that this exciter was used. The produced electroacoustic transducer was evaluated in the same manner. Electrodes were lead out from the individual piezoelectric films in the same manner.

As a result, in any of the electroacoustic transducers, almost the same results as in Examples 1 and 2 and Comparative Examples 1 to 3 in which the exciter was produced by folding back a long piezoelectric film of 5 × 100 cm were obtained.

Furthermore, a piezoelectric film of 25 × 20 cm was prepared, which was also alternately turned upside down and repeatedly folded back four times to produce an exciter of 5 × 20 cm. Even in this case, almost the same results as in Examples 1 and 2, and Comparative Examples 1 to 3 were obtained.

From the above results, the effect of the present invention is obvious.

The electroacoustic transducer can be suitably used as a speaker having flexibility for various usages.

### Explanation of References

- 10:: electroacoustic transducer
- 12:: vibration plate
- 14,56,60:: exciter
- 16, 19:: bonding layer
- 18, 18L:: piezoelectric film
- 18a, 18c:: sheet-like material
- 18b:: laminate
- 20:: piezoelectric layer
- 24:: lower (thin film) electrode
- 26:: upper (thin film) electrode
- 28:: lower protective layer
- 30:: upper protective layer
- 34:: viscoelastic matrix
- 36:: piezoelectric particles
- 40:: corona electrode
- 42:: direct-current power source
- 50:: vibration plate
- 58:: core rod
- PS:: power source

## Claims

1. An electro acoustic transducer comprising:
a vibration plate; and
an exciter provided on one principal surface of the vibration plate,
wherein a loss tangent of the exciter at a frequency of 1 Hz according to dynamic viscoelasticity measurement has a maximal value in a temperature range of 0°C to 50°C, the maximal value is 0.08 or more, and
a product of a thickness of the exciter and a storage elastic modulus at a frequency of 1 Hz and 25°C according to the dynamic viscoelasticity measurement is at most three times a product of a thickness of the vibration plate and a Young's modulus.

2. The electroacoustic transducer according to claim 1,
wherein a product of the thickness of the exciter and a storage elastic modulus at a frequency of 1 kHz and 25°C in a master curve obtained from the dynamic viscoelasticity measurement is at least 0.3 times the product of the thickness of the vibration plate and the Young's modulus.

3. The electroacoustic transducer according to claim 1 or 2,
wherein the loss tangent of the exciter at a frequency of 1 kHz and 25°C in the master curve obtained from the dynamic viscoelasticity measurement is less than 0.08.

4. The electroacoustic transducer according to any one of claims 1 to 3,
wherein the exciter has a piezoelectric film having a piezoelectric layer and electrode layers provided on both surfaces of the piezoelectric layer.

5. The electroacoustic transducer according to claim 4,
wherein the piezoelectric layer is a polymer-based piezoelectric composite material in which piezoelectric particles are dispersed in a matrix including a polymer material.

6. The electroacoustic transducer according to claim 4 or 5,
wherein the piezoelectric film has a protective layer provided on a surface of the electrode layer.

7. The electroacoustic transducer according to any one of claims 4 to 6,
wherein the piezoelectric film does not have in-plane anisotropy of piezoelectric properties.

8. The electroacoustic transducer according to any one of claims 4 to 7,
wherein the exciter has a laminate in which a plurality of layers of the piezoelectric films are laminated.

9. The electroacoustic transducer according to claim 8,
wherein the piezoelectric films are polarized in a thickness direction, and
polarization directions of the piezoelectric films adjacent to each other in the laminate are opposite to each other.

10. The electroacoustic transducer according to claim 8 or 9,
wherein the laminate is obtained by laminating a plurality of layers of the piezoelectric film by folding back the piezoelectric film one or more times.

11. The electroacoustic transducer according to any one of claims 8 to 10,
wherein the laminate has a bonding layer which bonds the piezoelectric films adjacent to each other.

12. The electroacoustic transducer according to any one of claims 1 to 11, further comprising:
a bonding layer for bonding the vibration plate to the exciter.
